# EUROPÄISCHE PATENTANMELDUNG

(11) **EP 4 160 335 A1**
(43) Veröffentlichungstag der Anmeldung: **05.04.2023**
(21) Anmeldenummer: 22196491.9
(22) Anmeldetag: 20.09.2022
(51) Int. Cl.: G05B 19/418

(54) **VERFAHREN UND VORRICHTUNG ZUR HERSTELLUNG EINER VIELZAHL VON BAUELEMENTEN MIT ZUMINDEST EINER ELEKTRISCHEN DURCHFÜHRUNG UND EINEM INFORMATIONSSPEICHER, BAUELEMENT SOWIE VERFAHREN UND VORRICHTUNG ZUR WEITERVERARBEITUNG SOLCHER BAUELEMENTE**

(30) Priorität: 30.09.2021 DE 102021125343
(71) Anmelder: SCHOTT AG, 55122 Mainz (DE)
(72) Erfinder: PFEIFFER, Thomas, 84036 Kumhausen (DE)
(74) Vertreter: Schott Corporate IP

(57) **Zusammenfassung**

Es wird ein Verfahren beschrieben zur Herstellung einer Vielzahl von Bauelementen mit zumindest einer elektrischen Durchführung, bei der ein Funktionselement in einer Durchführungsöffnung eines Grundkörpers mittels eines elektrisch isolierenden Materials fixiert ist. Bei dem Verfahren werden Informationen in Zuordnung zu jedem der Bauelemente erfasst wobei in einem der Herstellungsschritte des Verfahrens jedes Bauelement oder eine der Vorstufen jedes Bauelements mit einem Informationsspeicher versehen wird und wobei die Informationen in dem Informationsspeicher abgelegt werden und/oder in dem Informationsspeicher eine Kennung abgelegt wird und die Informationen in Zuordnung zu dieser Kennung in einer Datenbank hinterlegt werden.

Weitere Aspekte der Erfindung betreffen ein solches Bauelement, Ensembles mehrerer solcher Bauelemente, Vorrichtungen zur Herstellung solcher Bauelemente, Verfahren und Vorrichtungen zur Weiterverarbeitung solcher Bauelemente sowie die Verwendung der Bauelemente in einer Anzündeeinheit für Airbags oder einem Anzünder für Gurtstraffer.

## Beschreibung

Die Erfindung betrifft Verfahren zur Herstellung einer Vielzahl von Bauelementen mit zumindest einer elektrischen Durchführung, bei der ein Funktionselement in einer Durchführungsöffnung eines Grundkörpers mittels eines elektrisch isolierenden Materials fixiert ist, wobei Informationen in Zuordnung zu jedem der Bauelemente erfasst werden. Weitere Aspekte der Erfindung betreffen ein solches Bauelement, Ensembles mehrerer solcher Bauelemente, Vorrichtungen zur Herstellung solcher Bauelemente, Verfahren und Vorrichtungen zur Weiterverarbeitung solcher Bauelemente sowie die Verwendung der Bauelemente in einer Anzündeeinheit für Airbags oder einem Anzünder für Gurtstraffer.

Obwohl die vorliegende Erfindung allgemein auf beliebige Bauelemente anwendbar ist, wird die vorliegende Erfindung in Bezug auf Bauelemente in Form von Durchführungselementen von Anzündern für Airbags und/oder Gurtstraffern in Personenrückhaltesystemen erläutert.

Personenrückhaltesysteme werden in vielfältigster Weise in Fahrzeugen zu Lande, zu Wasser, im Raum oder in der Luft, insbesondere in Kraftfahrzeugen, eingesetzt, beispielsweise in Form von Gurtstraffern, die einen Zug auf einen Sitzgurt eines jeweiligen Insassen des Kraftfahrzeugs ausübt und die Rückhaltekraft auf den Insassen erhöht. Hierbei wird beispielsweise mittels eines Kolbens, der durch den von einem Gasgenerator erzeugten Gasdruck betrieben wird, ein Zug auf einen Sitzgurt ausgeübt.

Ein weiteres Personenrückhaltesystem sind Airbagsysteme, bei denen mit mittels zumindest eines in kürzester Zeit aufgeblasenen Luftsacks im Falle einer Fahrzeugkollision bei einem Seitenaufprall oder einem Frontalaufprall die Insassen des Fahrzeugs geschützt werden sollen. Die als Airbagsysteme ausgebildeten Personenrückhaltesysteme sollen mit Luftsäcken verhindern, dass die Fahrzeuginsassen auf die harte Struktur des Fahrzeugs aufprallen.

Derartige Airbagsysteme weisen häufig eine Anzündeeinheit und einen Festtreibstoff auf. Bei Zündung des Festtreibstoffs entsteht heißes Gas, welches durch einen Filter in den Luftsack strömt und diesen entfaltet. Daneben sind auch Airbagsysteme bekannt geworden, die mittels einer Anzündeeinheit einen Sprengsatz auslösen und eine Membran zwischen einem unter Druck stehenden Gasspeicher und dem zu entfaltenden Luftsack zerstören, sodass sich dieser entfaltet.

Die Anzündeeinheiten umfassen beispielsweise wie aus der EP 1 455 160 bekannt geworden, ein Durchführungselement mit einem Grundkörper für eine Zündkapsel bestehend aus einer kreisrunden Scheibe aus schweißbarem Material mit einer Oberseite und einer Unterseite und mit mindestens einer Durchgangsöffnung für eine Glasisolierung, wobei die mindestens eine Durchgangsöffnung an der Oberseite als Langloch ausgebildet ist und an der Unterseite kreisrund endet. In der Durchgangsöffnung wird elektrisch isolierend ein Kontaktstift in einem elektrisch isolierenden Fixiermaterial gehalten. Das Fixiermaterial ist üblicherweise ein glasiges oder glaskeramisches Material, in dem der Kontaktstift eingeschmolzen ist. Kunststoff-Fixiermaterialien sind ebenso bereits beschrieben.

An die aus der Durchgangsöffnung, der Glasisolierung und dem Kontaktstift gebildeten elektrischen Durchführung werden hohe Anforderungen gestellt, insbesondere bei Verwendung in einer Anzündeeinheit. Bei der Zündung der Anzündeeinheit muss sichergestellt sein, dass die Kontaktstifte nicht aus der Durchgangsöffnung herausgedrückt werden. Des Weiteren soll insbesondere das Eindringen von Feuchtigkeit aus der Umgebung in die Anzündeeinheit durch die elektrische Durchführung unterbunden werden, so dass die elektrische Durchführung bevorzugt hermetisch dicht ausgeführt ist.

Derartige Durchführungen für Anzündeeinheiten werden in manchen Produktionsschritten in vorgefertigten Bauelementeträgern, beispielsweise für je 100 Stück oder mehr, hergestellt. Eine Charge entsprechender Durchführungen für Anzündeeinheiten kann dabei mehrere 10.000 Stück umfassen, beispielsweise 80.000 Stück. Vor dem Versenden der hergestellten Durchführungen an den Hersteller der Anzündeinheiten werden diese einer stichprobenartigen oder 100% Ausgangskontrolle zur Qualitätssicherung unterzogen. Beim Hersteller der Anzündeinheit selbst werden wiederum die empfangenen Durchführungen einer genauen Eingangskontrolle unterzogen, um sicherzustellen, dass diese der jeweiligen mit dem Hersteller der Anzündeeinheiten vereinbarten Spezifikation entsprechen. Dies erfordert einen hohen Aufwand beim Hersteller der Anzündeinheiten.

Um den Aufwand zu reduzieren, ist es bekannt geworden, die Eingangskontrolle ebenfalls nur stichprobenartig durchzuführen, was allerdings dazu führt, dass die Genauigkeit bei der Überprüfung, ob die Durchführungen der Anzündeeinheiten der vereinbarten Spezifikation genügen oder nicht, auf Grund der großen Anzahl von Durchführungen schon in einer einzelnen Charge erheblich reduziert wird. Zudem kann eine einzelne als fehlerhaft erkannte Durchführung dazu führen, dass eine komplette Charge als fehlerhaft aussortiert wird. Wird die jeweilige Chargennummer dem Hersteller der Anzündeinheiten mitgeteilt, ist dieser jedoch, wenn überhaupt, nur äußerst begrenzt in der Lage zum einen zu ermitteln, was zu einer fehlerhaften Produktion der getesteten Anzündeeinheit geführt hat, zum anderen zu ermitteln, ob und ggf. in welchem Umfang auch weitere Anzündeeinheiten der jeweiligen Charge fehlerhaft sind. Darüber hinaus wird die Weiterverarbeitbarkeit der Anzündeeinheiten erheblich erschwert, da bei Feststellung einer einzigen fehlerhaften Anzündeeinheit einer Charge dann die komplette Charge getestet bzw. überprüft werden muss oder eine neue Charge verwendet werden muss. Die Ergebnisse der Überprüfung können dazu verwendet werden, beim Hersteller ebenso Chargen auszusortieren oder zu prüfen.

Dies vorausgeschickt ist es eine Aufgabe der Erfindung, ein Bauelement zur Verfügung zu stellen, dem Informationen zugeordnet sind, die für die Beurteilung der Qualität und zur Nachverfolgbarkeit benötigt werden.

Ebenso ist es eine Aufgabe der Erfindung, ein Verfahren sowie eine Vorrichtung zur Verfügung zu stellen, welche die Herstellungsparameter eines Bauelements während dessen Herstellung nachverfolgbar macht.

Eine weitere Aufgabe der Erfindung ist es, ein Verfahren sowie eine Vorrichtung zur Verfügung zu stellen, welches die einem Bauelement zugeordneten Informationen bei der Weiterverarbeitung des Bauelements zu Einheiten, welche mindestens ein solches Bauelement enthalten, verfügbar macht. Insbesondere werden die Informationen dabei verwendet, um die Weiterverarbeitung der Bauelemente zu den Einheiten unter Verwendung der den Bauelementen zugeordneten Informationen zu steuern.

Damit betrifft die Erfindung insbesondere die gesamte Herstellungskette vom Einsatz der Materialien zur Herstellung des Bauelements und die Weiterverarbeitung des Bauelements zu Einheiten, welche jeweils zumindest ein solches Bauelement enthalten. Die Erfindung betrifft dabei auch Herstellungsverfahren mit einer Ausgangskontrolle der Bauelemente als Zwischenprodukt und Weiterverarbeitungsverfahren mit einer Eingangskontrolle bei einem Weiterverarbeiter, der die Bauelemente zu den Einheiten weiterverarbeitet, welche das Endprodukt im Sinne der vorliegenden Beschreibung darstellen.

### Offenbarung der Erfindung

Es wird ein Verfahren zur Herstellung einer Vielzahl von Bauelementen vorgeschlagen. Die Bauelemente weisen zumindest eine elektrische Durchführung auf, bei der ein Funktionselement in einer Durchführungsöffnung eines Grundkörpers mittels eines elektrisch isolierenden Materials fixiert ist. Bei dem Verfahren ist vorgesehen, Informationen betreffend ein Bauelement in Zuordnung zu jedem der Bauelemente zu erfassen. Diese Informationen sind dabei bevorzugt ausgewählt aus einem oder mehreren aus der Gruppe von Informationen betreffend verwendete Ausgangsmaterialien, Informationen betreffend ausgeführte Herstellungsschritte, Informationen betreffend verwendete Werkzeuge und Anlagen, Informationen betreffend Messungen und einer eindeutigen Kennung.

Bevorzugt ist zumindest eine der Informationen spezifisch für individuelle Bauelemente, insbesondere für jedes einzelne der Bauelemente.

Ferner ist vorgesehen, dass in einem der Herstellungsschritte des Verfahrens jedes Bauelement oder eine der Vorstufen jedes Bauelements mit einem Informationsspeicher versehen wird, wobei dem Bauteil zugeordnete Informationen in dem Informationsspeicher abgelegt werden. Alternativ oder zusätzlich dazu wird in dem Informationsspeicher eine eindeutige Kennung bzw. ID abgelegt und die weiteren dem Bauelement zugeordneten Informationen werden in Zuordnung zu dieser Kennung in einer Datenbank hinterlegt. Der Informationsspeicher kann beispielsweise als eine optische auslesbare Markierung ausgeführt werden, insbesondere als ein Barcode oder als ein Matrixcode, der die Kennung bzw. ID kodiert. Aber auch andere Ausführungsformen wie beispielsweise als ein elektronischer Speicher wie ein RFID-Chip oder ein Flash-Speicher sind denkbar.

Die Datenbank wird bevorzugt über eine Computereinrichtung implementiert, bei der es sich beispielsweise um einen Server, insbesondere um einen Cloud-Server, handeln kann, welche über ein Datennetzwerk mit anderen Computereinrichtungen kommunizieren kann. Bei dem Datennetzwerk kann es sich um ein lokales Netzwerk handeln, welches beispielsweise in einer Produktionsstätte mehrere Einrichtungen miteinander vernetzt. Bevorzugt handelt es sich bei dem Datennetzwerk um das Internet, so dass die in der Datenbank abgelegten Informationen zu jeder Zeit von einem beliebigen Ort aus abgerufen werden können.

Das Bauelement, welches insbesondere mit dem vorgeschlagenen Verfahren erhalten wird, ist bevorzugt dazu ausgebildet und/oder eingerichtet, in einem Weiterverarbeitungsschritt als Bestandteil in einer Einheit aufgenommen zu werden, wobei das Bauelement in dieser Einheit zumindest eine elektrische Durchführung bereitstellt.

Das Bauelement kann hierzu beispielsweise einen Grundkörper umfassen, der für jede der elektrischen Durchführungen eine Durchgangsöffnung aufweist. Der Grundkörper ist bevorzugt aus einem Metall gefertigt, wobei die Durchgangsöffnung beispielsweise durch Stanzen, Fräsen oder Bohren erzeugt werden kann.

In der Durchgangsöffnung ist ein Funktionselement angeordnet, welches beispielsweise als ein Anschlussstift, insbesondere als ein Metallstift, ausgeführt sein kann. Das Funktionselement ist in der Durchgangsöffnung mit einem elektrisch isolierenden Material fixiert. Das elektrisch isolierende Material ist bevorzugt ein Glas, eine Glaskeramik oder eine Keramik. Denkbar ist aber auch die Verwendung anderer elektrisch isolierender Materialien, wie beispielsweise ein Kunststoff, oder Mischungen mehrerer isolierender Materialien, wie beispielsweise eine Mischung aus einem Glas und einem Kunststoff.

Durch das Umgeben und Fixieren des Funktionselements in der Durchgangsöffnung mit dem elektrisch isolierenden Material wird die Durchgangsöffnung verschlossen und damit abgedichtet. Bevorzugt ist diese Abdichtung hermetisch dicht, um insbesondere das Eindringen von Feuchtigkeit durch die elektrische Durchführung zu unterbinden. Als hermetisch dicht wird hierbei eine elektrische Durchführung verstanden, die eine Heliumleckrate von weniger als 1·10⁻⁵ mbar·l/sec aufweist und bevorzugt im Bereich 1·10⁻¹⁰ mbar !/sec bis 1·10⁻⁶ mbar·l/sec liegt. Bevorzugt wird die Heliumleckrate gemäß DIN EN60068-2-17 oder MIL-STD-883-method 1014.9 condition A4 gemessen.

Bevorzugt wird bei dem Verfahren jedes Bauelement oder eine Vorstufe jedes Bauelements in zumindest einem Herstellungsschritt eindeutig über seine Lage in einem Bauelementeträger identifiziert. Dem Bauelementeträger ist dabei bevorzugt eine Bauelementeträgerkennung zugeordnet, die diesen eindeutig identifiziert. Diese Bauelementeträgerkennung ist beispielsweise in einem am Bauelement angeordneten Informationsspeicher abgelegt. Entsprechend ist es bevorzugt, in dem Herstellungsschritt des Verfahrens die Bauelemente bzw. deren Vorstufen durch das Auslesen des Informationsspeichers des Bauelementeträgers und die Position in dem Bauelementeträger zu identifizieren. Der Informationsspeicher des Bauelementeträgers kann beispielsweise als ein RFID-Chip oder als eine optische auslesbare Markierung ausgeführt werden, insbesondere als ein Barcode oder als ein Matrixcode, der die Bauelementeträgerkennung kodiert.

Bei dem Bauelementeträger kann es sich beispielsweise um ein Formwerkzeug handeln, welches mehrere Bauelemente bzw. deren Vorstufen aufnimmt, z.B. um Glasrohlinge zu sintern oder nach einer Montage der Metallstifte eine Einglasung in einem Ofen vorzunehmen. Der Bauelementträger kann jede Art von Halterung sein, mit der das Bauelement bzw. dessen Vorstufen bei dem Herstellungsverfahren gehandhabt werden.

Bevorzugt wird jedes Bauelement oder eine Vorstufe jedes Bauelements in zumindest einem Herstellungsschritt des Verfahrens über das Auslesen des Informationsspeichers des Bauelements eindeutig identifiziert.

Ein Ausführungsbeispiel des Verfahrens kann beispielsweise als einen Schritt das Bereitstellen eines Ausgangsmaterials für den Grundkörper umfassen. In einem nachfolgenden Schritt erfolgt die Formgebung des Grundkörpers, beispielsweise unter Verwendung von Stanzen, Prägen, Fräsen, Bohren und dergleichen, wobei zumindest eine Durchgangsöffnung in dem Grundkörper ausgebildet wird. Dabei ist insbesondere vorgesehen, nach einem Abtrennen des Grundkörpers aus einem Ausgangsmaterial, beispielsweise nach einem Ausstanzen aus einem Blech oder einem Abtrennen von einem Stangenmaterial, jeden Grundkörper individuell nachzuverfolgen. Da zu diesem Zeitpunkt noch kein Informationsspeicher mit dem Grundkörper verbunden ist, wird das Nachverfolgen über die Position des jeweiligen Grundkörpers in der verarbeitenden Vorrichtung durchgeführt, beispielsweise, indem der Grundkörper nach dem Abtrennen aus dem Ausgangsmaterial in eine vorgegebene Position eines Bauelementeträgers abgelegt wird. Entsprechend können Angaben wie beispielsweise das jeweils verwendete Ausgangsmaterial, das zur Ausbildung des Grundkörpers verwendete Werkzeug und/oder der Zeitpunkt der Herstellung diesem konkreten Grundkörper als Ausgangsprodukt für das spätere Bauelement als Information zugeordnet werden. Alternativ zu einer individuellen Nachverfolgung jedes einzelnen Grundkörpers kann zu diesem Zeitpunkt des Verfahrens aber auch eine Nachverfolgung einer Charge von Grundkörpern durchgeführt werden, wobei der gesamten Charge von Grundkörpern dieselben Informationen zugeordnet werden.

Das Verfahren umfasst ebenso das Bereitstellen des elektrisch isolierenden Materials. Das elektrisch isolierende Material kann beispielsweise in Form eines Pulvers bereitgestellt werden, welches zu einem Rohling zum Einsetzen in die Durchgangsöffnung des Grundkörpers geformt wird, beispielsweise durch Sintern. Wiederum kann dieser Rohling nach dem Formen individuell über das Verfolgen seiner Position in der verarbeitenden Vorrichtung nachverfolgt werden, beispielsweise durch das Verfolgen der Position des Rohlings in einem Träger. Dem jeweiligen Rohling als Ausgangsprodukt für das spätere Bauelement können entsprechend Angaben wie beispielsweise das jeweils verwendete Ausgangsmaterial, das zum Formen des Rohlings verwendete Werkzeug und/oder der Zeitpunkt der Herstellung als Information zugeordnet werden. Alternativ zu einer individuellen Nachverfolgung jedes einzelnen Rohlings kann zu diesem Zeitpunkt des Verfahrens aber auch eine Nachverfolgung einer Charge von Rohlingen durchgeführt werden, wobei der gesamten Charge von Rohlingen dieselben Informationen zugeordnet werden.

Des Weiteren umfasst das Verfahren das Bereitstellen eines Funktionselements, beispielsweise in Form eines Anschlussstifts, insbesondere eines Metallstifts. Der Metallstift kann beispielsweise durch Abtrennen aus einem in Form eines Drahts bereitgestellten Ausgangsmaterials erhalten werden. Der Metallstift kann nach dem Abtrennen individuell über das Verfolgen der Position des Metallstifts in der verarbeitenden Vorrichtung nachverfolgt werden, beispielsweise durch das Verfolgen der Position des Metallstifts in einem Träger. Dem jeweiligen Metallstift als Ausgangsprodukt für das spätere Bauelement können entsprechend Angaben wie beispielsweise das jeweils verwendete Ausgangsmaterial, das zum Erhalten des Metallstifts verwendete Werkzeug und/oder der Zeitpunkt der Herstellung als Information zugeordnet werden. Alternativ zu einer individuellen Nachverfolgung jedes einzelnen Metallstifts kann zu diesem Zeitpunkt des Verfahrens aber auch eine Nachverfolgung einer Charge von Metallstiften durchgeführt werden, wobei der gesamten Charge von Metallstiften dieselben Informationen zugeordnet werden.

Den Bereitstellungsschritten, welche parallel oder nacheinander in beliebiger Reihenfolge ausgeführt werden können, schließt sich ein Montageschritt an. In dem Montageschritt werden jeweils ein Metallstift und ein Rohling in eine Durchgangsöffnung des Grundkörpers eingesetzt. Dem Montageeschritt folgt ein Schmelzschritt, in dem der Rohling aufgeschmolzen wird und die hermetisch dichte elektrische Durchführung erhalten wird.

Der Montageschritt und der Schmelzschritt erfolgen unter Verwendung eines Bauelementeträgers, der eindeutig identifizierbare Aufnahmen für die herzustellenden Bauelemente aufweist. Der Bauelementeträger ist beispielsweise als Graphit-Form ausgestaltet, wobei jede der Aufnahmen als eine Vertiefung in der Graphit-Form bzw. Kohleform ausgebildet ist. In dem Montageschritt wird beispielsweise eine Graphit-Form als ein Bauelementeträger, der eindeutig identifizierbar ist, bereitgestellt. Anschließend werden in jede der Aufnahmen der Graphit-Form jeweils ein Grundkörper eingesetzt und in jede Durchgangsöffnung des Grundkörpers ein Rohling und ein Metallstift eingesetzt. Dabei werden jeder Aufnahme der Graphit-Form, welche eindeutig identifiziert werden kann, die den eingesetzten Vorstufen des Bauelements zugeordneten Informationen zugeordnet, so dass beispielsweise die verwendeten Materialien, Werkzeuge und Herstellungszeitpunkte für den Grundkörper, den Rohling und den Metallstift auch im Zusammenhang mit jeder Aufnahme der Graphit-Form nachverfolgt werden können.

Die so bestückte Graphit-Form wird anschließend zur Ausführung des Schmelzschritts in einen Ofen eingebracht und verweilt dort für eine vorgegebene Zeit bei einer vorgegebenen Temperatur, um die fertige elektrische Durchführung zu erhalten. Die Parameter für die Durchführung des Schmelzschritts werden wiederum der Graphit-Form als Bauelementeträger und damit allen in diesem Bauelementeträger aufgenommenen Bauelementen zugeordnet.

An den Schmelzschritt schließt sich bevorzugt ein Kontrollschritt an, in dem alle gefertigten Bauelemente oder zumindest eine Stichprobe der gefertigten Bauelemente vermessen werden. Das Ergebnis dieser Vermessung wird bevorzugt diesen Bauelementen als weitere Information zugeordnet.

Das Verfahren zur Herstellung kann weitere Herstellungsschritte umfassen. Beispielsweise kann in einem Beschichtungsschritt eine Beschichtung von Oberflächen erfolgen, beispielsweise von bestimmten Vorstufen des Bauelements wie dem Grundkörper und den Anschlussstiften. Hierzu kann gegebenenfalls als Vorbereitung ein Vorbehandlungsschritt vorgesehen sein, in dem die zu beschichtenden Oberflächen gereinigt und/oder gebeizt werden.

Vor einer Ausgabe der Bauelemente ist bei dem vorgeschlagenen Verfahren vorgesehen, einen Informationsspeicher an dem Bauelement bzw. an einem Vorprodukt des Bauelements anzuordnen. Dieses Anordnen des Informationsspeichers kann zu verschiedenen Zeitpunkten in dem Herstellungsverfahren erfolgen. Ein am Grundkörper angeordneter Informationsspeicher kann nach dem Bereitstellen des Grundkörpers jederzeit an diesem angeordnet werden. Entsprechend kann ein an einem Metallstift angeordneter Informationsspeicher jederzeit nach dem Bereitstellen des Metallstifts an diesem angeordnet werden.

Nach dem Anordnen des Informationsspeichers, kann dieser ausgelesen werden, um ein Bauelement oder eine Vorstufe des Bauelements eindeutig zu identifizieren. Zu diesem Zweck ist bevorzugt vorgesehen, dass der Informationsspeicher eine eindeutige Kennung als Information enthält.

Die während der einzelnen Herstellungsschritte des Verfahrens in Zuordnung zu dem Bauelement bzw. dessen Vorprodukten erhaltenen Informationen werden bevorzugt in einer Datenbank abgelegt und über die in dem Informationsspeicher abgelegte Kennung mit dem jeweiligen Bauelement verknüpft. Dabei kann insbesondere vorgesehen sein, dass diese dem Bauelement zugeordneten Informationen fortlaufend ergänzt werden, beispielsweise nach jedem oder nach ausgewählten Schritten des Verfahrens zur Herstellung. Diese Schritte können dabei insbesondere Bearbeitungsschritte und Inspektionsschritte umfassen.

Bevorzugt erfolgt bei dem Verfahren zur Herstellung eine Abschlusskontrolle, der eine Stichprobe der Bauelemente oder jedes Bauelement unterzogen wird, bei der zumindest eine Eigenschaft des Bauelements gemessen wird, und Ergebnisse dieser Abschlusskontrolle dem Bauelement als Information zugeordnet werden. Eine solche Abschlusskontrolle ist insbesondere bei der Produktion von sicherheitsrelevanten Bauelementen, wie Durchführungen für Anzündeeinheiten für Airbags und/oder Gurtstraffer vorteilhaft.

Bei den Eigenschaften des Bauelements kann es sich beispielsweise um geometrische Eigenschaften wie die Abmessungen des Bauelements handeln. Des Weiteren können beispielsweise Eigenschaften wie der Isolationswiderstand zwischen dem Funktionselement und dem Grundkörper, die Dichtigkeit der elektrischen Durchführung bei der Abschlusskontrolle geprüft werden. Auch ist es denkbar, eine Stichprobe der Bauelemente auf eine Auspresskraft der elektrischen Durchführung zu überprüfen.

Bevorzugt werden die bei der Abschlusskontrolle erhaltenen Ergebnisse mit vorgegebenen Sollwerten verglichen und es werden bevorzugt Bauelemente ermittelt, bei denen mindestens eine Überschreitung vorgegebener Grenzwerte vorliegt. Auf diese Weise können Bauelemente ermittelt werden, welche vorgegebene Anforderungen nicht erfüllen. Diese identifizierten Bauelemente können verworfen werden, sofern möglich nachgearbeitet werden oder gegebenenfalls in eine niedrigere Qualitätsklasse eingeteilt werden.

Werden Bauelemente einer Nacharbeitung unterzogen, werden bevorzugt auch hierbei Informationen erfasst und dem Bauteil zugeordnet. Diese Informationen können insbesondere Angaben zu den verwendeten Materialien, Werkzeugen und Anlagen sowie die einzelnen bei der Nacharbeitung angewendeten Schritte umfassen. Der Informationsspeicher bzw. ein zugeordneter Datenbankeintrag können dann entsprechend ergänzt werden.

Die Ausgabe der Bauelemente kann einen Verpackungsschritt umfassen, bei dem eine Gesamtheit von Bauelementen bzw. eine Charge von Bauelementen in einem Träger wie einer Umverpackung aufgenommen und verpackt werden. Diese Umverpackung kann mit einem Ensembleinformationsspeicher versehen werden, der Informationen zur Umverpackung selbst sowie zu den einzelnen darin aufgenommenen Bauelementen umfassen kann. Beispielsweise können eine Chargennummer oder die eindeutigen Kennungen der enthaltenen Bauelemente in dem Ensembleinformationsspeicher abgelegt sein. Denkbar ist hier aber auch, beispielsweise die eindeutigen Kennungen der in der Umverpackung aufgenommenen Bauelemente in einer Datenbank abzulegen und mit einer Kennung der Umverpackung zu verknüpfen, die dann in dem Ensembleinformationsspeicher hinterlegt wird.

Bevorzugt ist bei dem Verfahren zumindest ein Schritt vorgesehen, bei dem für die ermittelten Bauelemente mit mindestens einer Grenzwertüberschreitung deren zugeordneten Informationen ausgewertet werden und für die ermittelten Bauelemente gemeinsame Informationen bestimmt werden, welche für die ermittelten Bauelemente identisch sind oder bis auf eine vorgegebene Toleranz übereinstimmen.

Bei diesem Schritt werden Gemeinsamkeiten der Bauelemente mit ermittelten Abweichungen bestimmt. Beispielsweise könnte hier festgestellt werden, dass alle Bauelemente, welche in einer bestimmten Form aufgenommen waren, mit einem bestimmten Werkzeug bearbeitet wurden, in einem bestimmten Ofen behandelt wurden oder von einem bestimmten Operator bearbeitet wurden nicht den Anforderungen genügen und daher für mindestens eine Eigenschaft einen vorgegebenen Grenzwert überschreiten bzw. unterschreiten. Das Identifizieren solcher Gemeinsamkeiten ist insbesondere zum Erkennen von Ursachen für die Nichteinhaltung der Grenzwerte hilfreich.

Das Auswerten der Informationen der ermittelten Bauelemente mit mindestens einer Grenzwertüberschreitung kann beispielsweise unter Verwendung von Maschinenlernverfahren bzw. künstlicher Intelligenz erfolgen. Beispielsweise können hierdurch komplexe Korrelationen zwischen bestimmten Produktionsmitteln oder Produktionsbedingungen erkannt werden.

Bevorzugt ist bei dem Verfahren ferner vorgesehen, dass aus den gemeinsamen Informationen Herstellungsschritte, Ausgangsmaterialien, Werkzeuge und/oder Prozessbedingungen ermittelt werden, welche diese Bauelemente gemeinsam haben, und dass entsprechend dem Ergebnis dieser Bestimmung Maßnahmen zur Qualitätsverbesserung zukünftiger Durchläufe der Herstellungsschritte des Verfahrens eingeleitet werden. Bevorzugt sind diese Maßnahmen ausgewählt aus dem Austausch eines Werkzeugs, dem Austausch eines Bauelemente-trägers, dem Austausch oder der Eichung eines Messgeräts, der Vornahme von Korrekturen von Prozessparametern, der Auswahl anderer Ausgangsmaterialien, der Korrelation verschiedener Fertigungsprozesse und Kombinationen mehrerer dieser Maßnahmen.

Wird beispielsweise bei dem Verfahren festgestellt, dass alle Bauelemente, die mit einem bestimmten Werkzeug bearbeitet wurden einen vorgegebenen Grenzwert nicht einhalten, kann darauf geschlossen werden, dass dieses Werkzeug verschlissen ist. Als eine Maßnahme kann dann das betroffene Werkzeug ausgetauscht werden.

Bei dem vorgeschlagenen Verfahren kann die Nachverfolgbarkeit der einzelnen Bauelemente und die Zuordnung der spezifischen Informationen zu diesen einzelnen Bauelementen vorteilhafter Weise dazu verwendet werden, das Verfahren zur Herstellung dieser Bauelemente fortlaufend zu überwachen und zu optimieren. Insbesondere bei einstellbaren Prozessparametern wie z.B. der Temperatur und der Dauer bei der Durchführung des Schmelzschritts kann wie bei einer Regelschleife eine Optimierung der Prozessparameter erfolgen.

Bei dem Verfahren können vorteilhafter Weise bereits wesentliche Parameter des jeweiligen Bauelements bereits vor der Herstellung demselben oder einer Gesamtheit von Bauelementen zugeordnet werden und anhand der jeweiligen Kennung individuell für jedes Bauelement oder Gesamtheit bzw. Gruppe von Bauelementen hinterlegt werden. Insbesondere können bereits Ausgangsmaterialien und/oder Vorstufen des Bauelements individuell nachverfolgt und später dem Bauelement zugeordnet werden, in dem diese verbaut wurden. Dies ermöglicht die Bereitstellung einer Vielzahl für die Herstellung, Produktion und Weiterverarbeitung jedes der Bauelemente relevanten Parameter, die auf einfache Weise dann bei der Fehlersuche bei als defekt erkannten Bauelementen zur Verfügung stehen. Damit wird eine schnellere und effizientere Fehlersuche ermöglicht. Gleichzeitig kann die Produktion engmaschiger überwacht und fehlerhafte Bauelemente ggf. noch vor der Auslieferung an Kunden bzw. Weiterverarbeiter erkannt und aussortiert werden. Daneben kann die Produktion schneller umgestellt oder korrigiert werden, was den Ausschuss bei der Produktion von Bauelementen verringert und die Qualität bei der Herstellung verbessert. Ein weiterer Vorteil ist, dass bereits dem Kunden bzw. Weiterverarbeiter ausgewählte Daten individuell für jedes bezogene Bauelement oder Gruppe von Bauelementen übermittelt werden können, sodass dessen Eingangskontrolle ganz oder zumindest teilweise entfallen kann, was Zeit und Kosten spart.

Ein weiterer Aspekt der Erfindung betrifft ein Bauelement mit zumindest einer elektrischen Durchführung, bei der ein Funktionselement in einer Durchführungsöffnung eines Grundkörpers mittels eines elektrisch isolierenden Materials fixiert ist, wobei das Bauelement einen Informationsspeicher umfasst. Der Informationsspeicher ist bevorzugt fest in das Bauelement integriert oder untrennbar mit diesem verbunden.

Das Bauelement wird bevorzugt über eines der hierin beschriebenen Verfahren zur Herstellung erhalten.

Die Erfindung betrifft auch ein Ensemble von solchen Bauelementen, wobei das Ensemble von Bauelementen in einem Behälter aufgenommen ist, wobei der Behälter einen Ensembleinformationsspeicher umfasst und wobei der Ensembleinformationsspeicher Angaben zur Identifizierung der in dem Ensemble enthaltenen Bauelemente enthält.

Der Behälter kann dabei als ein Bauelementeträger ausgestaltet sein oder einen solchen umfassen, wobei der Bauelementeträger beispielsweise als plattenförmiges Element mit einer Vielzahl von Vertiefungen zur Aufnahme von jeweils einem Bauelement ausgestaltet ist.

Der Ensembleinformationsspeicher kann beispielsweise eine Ensemblekennung umfassen, über die Informationen darüber, welche Bauelemente Teil des Ensembles sind, aus einer Datenbank abgerufen werden können. Die entsprechenden Informationen können aber auch direkt in dem Ensembleinformationsspeicher selbst abgelegt sein. Die Informationen über die Bauelemente des Ensembles können wiederum als Kennung für den Abruf zugeordneter Informationen aus einer Datenbank ausgestaltet sein und/oder ebenfalls direkt in dem Ensembleinformationsspeicher abgelegt sein.

Der Ensembleinformationsspeicher ermöglicht es einem Empfänger oder einem Weiterverarbeiter die Informationen einer Vielzahl von Bauelementen in einem Schritt in ein Datenverarbeitungssystem wie eine einer Produktionsanlage zugeordnete Computereinrichtung zu übernehmen, ohne dass der Informationsspeicher jedes einzelnen Bauelements selbst ausgelesen werden muss. Da aber jedes einzelne Bauelement über einen eigenen Informationsspeicher verfügt, können die entsprechenden bauteilbezogenen Informationen im Laufe eines Weiterverarbeitungsprozesses jedem einzelnen Bauelement individuell zugeordnet werden.

Ein weiterer Aspekt der Erfindung betrifft ein Verfahren zur Weiterverarbeitung von den beschriebenen Bauelementen, einem Ensemble von Bauelementen oder über eines der hierin beschriebenen Verfahren erhaltener Bauelemente zu Einheiten, welche jeweils mindestens eines dieser Bauelement enthalten. Dabei ist vorgesehen, dass jeweils einem Bauelement zugeordnete Informationen erhalten werden und jeweils einer der Einheiten zugeordnet werden. Ferner ist vorgesehen, dass das Erhalten der einem Bauelement zugeordneten Informationen ein Auslesen eines Informationsspeichers des Bauelements oder ein Auslesen eines Ensembleinformationsspeichers eines Behälters, der ein oder mehrere Bauelemente aufnimmt, umfasst.

Das Verfahren zur Weiterverarbeitung kann direkt im Anschluss an das Verfahren zur Herstellung durchgeführt werden oder zu einem beliebigen späteren Zeitpunkt durchgeführt werden. Entsprechend betrifft die Erfindung auch kombinierte Verfahren bei denen ein Bauelement zunächst hergestellt wird und im Anschluss zu der Einheit weiterverarbeitet wird. Das Verfahren zur Weiterverarbeitung kann insbesondere an einem anderen Ort von einem Weiterverarbeiter ausgeführt werden, der die Bauelemente als Vorprodukt von einem Bauteilproduzenten bezieht.

Bei dem Verfahren zur Weiterverarbeitung wird bevorzugt in zumindest einem Weiterverarbeitungsschritt zumindest ein Parameter anhand von dem Bauelement zugeordneten Informationen angepasst.

Beispielsweise können hier geometrische Parameter eines Bauelements durch Auslesen des Informationsspeichers des jeweiligen Bauelements erfasst werden und davon abhängige Prozessparameter bei der Weiterverarbeitung des Bauelements zu der Einheit berücksichtigt werden.

Ein in den dem Bauelement zugeordneten Informationen enthaltener Parameter kann bei dem Verfahren zur Weiterverarbeitung erneut gemessen werden und mit den entsprechenden über den dem Bauelement zugeordneten Informationsspeicher erhaltenen Informationen verglichen werden.

Bevorzugt wird der Vergleich für mehrere Bauelemente wiederholt, welche eine Stichprobe aus einer Gesamtheit der Bauelemente sind, oder der Vergleich wird für alle Bauelemente der Gesamtheit wiederholt, wobei bei Erkennen einer systematischen Abweichung ein Korrekturfaktor ermittelt wird, mit dem zugeordnete Informationen auch für nicht erneut vermessene Bauteile dieser Gesamtheit korrigiert werden.

Bei der Gesamtheit der Bauelemente kann es sich insbesondere um die Bauelemente eine Charge oder die Bauelemente eines Ensembles handeln.

Dieses wiederholte Messen von Parametern eines Bauelements und Vergleichen mit den entsprechenden zuvor diesem Bauelement zugeordneten Informationen erlaubt es beispielsweise unterschiedliche Kalibrierungen von Messapparaturen zu erkennen und über einen Korrekturfaktor zu berücksichtigen, so dass nach einer entsprechenden Korrektur die in Zuordnung zu den einzelnen Bauelementen gespeicherten Informationen für eine Steuerung des Verfahrens zur Weiterverarbeitung eingesetzt werden können, ohne die entsprechenden Parameter für jedes einzelne Bauelement neu vermessen zu müssen.

Des Weiteren kann das wiederholte Messen von Parametern eines Bauelements und Vergleichen mit den entsprechenden zuvor diesem Bauelement zugeordneten Informationen dazu dienen, bei einem Weiterverarbeiter der Bauelemente die Zuverlässigkeit der zuvor bei der Herstellung der Bauelemente ermittelten und gespeicherten Informationen zu Zwecken der Qualitätssicherung zu überwachen und zu dokumentieren.

Bei dem vorgeschlagenen Verfahren zur Weiterverarbeitung von Bauelementen zu Einheiten, welche jeweils mindestens ein solches Bauelement enthalten, kann insbesondere zum Zwecke der Qualitätssicherung der Informationsspeicher der einzelnen Bauelemente und/oder ein Ensembleinformationsspeicher eines Behälters mit einer Vielzahl von Bauelementen ausgelesen werden und Messungen bzw. Prüfungen von vorgegebenen Parametern der Bauelemente im Rahmen einer Eingangskontrolle ergänzen oder ersetzen. Werden bei der Eingangskontrolle Bauelemente identifiziert, welche für zumindest einen Parameter vorgegebene Grenzwerte über- bzw. unterschreiten, können die den einzelnen Bauelementen zugeordneten Informationen vorteilhafter Weise dazu verwendet werden, weitere Bauelemente zu identifizieren, welche ebenfalls Grenzwertüberschreitungen aufweisen könnten. Dies kann beispielsweise dadurch erfolgen, dass Informationen der Bauteile mit Grenzwertüberschreitungen bzw. Grenzwertunterschreitungen auf Gemeinsamkeiten untersucht werden. Wird beispielsweise erkannt, dass alle Bauelemente, die unter Verwendung eines bestimmten Werkzeugs hergestellt wurden einen vorgegebenen Grenzwert nicht einhalten, müssen nur diese verworfen werden und andere Bauelemente aus derselben Gesamtheit können für die Weiterverarbeitung verwendet werden. Des Weiteren können diese Kenntnisse verwendet werden, um die Herstellung weiterer Bauelemente zu optimieren.

Die Anordnung eines Informationsspeichers an dem Bauelement erleichtert die eindeutige Zuordnung von bei der Weiterverarbeitung erkannter Fehlerbilder zu bestimmten Bedingungen bzw. Mitteln bei der Herstellung der Bauelemente. Da die Nachverfolgung beim Verfahren zur Herstellung der Bauelemente bereits bei den jeweiligen Ausgangsmaterialien und Vorstufen einsetzen kann, können bestimmte Fehlerbilder sogar einzelnen Vorprodukten und Ausgangsmaterialien der Bauelemente zugeordnet werden. Durch diese Zuordnung kann von einem Weiterverarbeiter der Bauelemente eine Rückmeldung zum Hersteller der Bauelemente erfolgen, beispielsweise um das Herstellungsverfahren zu optimieren und/oder um weitere Bauelemente mit Grenzwertüberschreitungen noch vor einer Auslieferung zu verwerfen oder nachzuarbeiten. Dabei ist eine solche Zuordnung insbesondere dann noch möglich, wenn Bauelemente verschiedener Chargen gemischt wurden, da jedes Bauelement individuell mit einem Informationsspeicher versehen ist.

Diese Vorteile können auch dann realisiert werden, wenn die Herstellung der Bauelemente und deren Weiterverarbeitung zu den Einheiten räumlich, zeitlich und/oder organisatorisch getrennt voneinander erfolgen. Insbesondere können die Herstellung der Bauelemente und deren Weiterverarbeitung zu den Einheiten in unterschiedlichen Fertigungsstätten erfolgen. Dabei kann insbesondere der Weiterverarbeiter der Bauelemente organisatorisch vom Hersteller der Bauelemente unabhängig sein. Sofern der Informationsspeicher der Bauelemente die zugeordneten Informationen nicht direkt enthält, sondern eine Kennung für einen Abruf der Informationen aus einer Datenbank speichert, kann beispielsweise der Hersteller der Bauelemente die Datenbank bereitstellen, wobei dem Weiterverarbeiter der Bauelemente über ein Datennetzwerk wie das Internet ein Zugriff auf die Datenbank ermöglicht wird. Dabei kann vorgesehen sein, die Zugriffsrechte zu beschränken, so dass der Weiterverarbeiter nur einen lesenden Zugriff erhält und/oder nur ausgewählte Informationen zu einem Bauelement abrufen darf.

Der Weiterverarbeiter kann analog zu dem Vorgehen bei der Herstellung der Bauelemente auch bei der Weiterverarbeitung zu einer Einheit Informationen in Zuordnung zu individuellen Einheiten erfassen und in eindeutiger Zuordnung zu einer Einheit speichern. Wiederum kann das Speichern beispielsweise in einem an der Einheit angeordneten Informationsspeicher erfolgen, oder ein an der Einheit angeordneter Informationsspeicher enthält eine eindeutige Kennung, die einen Zugriff auf einen in einer Datenbank abgelegten Datensatz mit den zugeordneten Informationen ermöglicht. Sofern ein Informationsspeicher eines in der Einheit verbauten Bauelements nach der Weiterverarbeitung noch zugänglich ist, kann dieser hierfür weitergenutzt werden und beispielsweise die gesamte Einheit nachverfolgbar machen. Andernfalls kann ein weiterer Informationsspeicher an der Einheit angeordnet werden.

Bevorzugt ist vorgesehen, Informationen betreffend die verwendeten Ausgangsmaterialien und/oder die ausgeführten Herstellungsschritte und/oder Angaben zu verwendeten Werkzeugen und Anlagen und/oder Angaben und Ergebnisse zu Messungen, insbesondere von einer nach einem Herstellungsschritt durchgeführten Messung, und/oder eine eindeutige Kennung in Zuordnung zu jedem der Bauelemente zu erfassen.

Die eindeutige Kennung kann dabei zum einen für eine eindeutige Identifikation des jeweiligen Bauelements verwendet werden. Werden nicht alle dem Bauelement zugeordneten Information in dem Informationsspeicher selbst, sondern in einer Datenbank erfasst, kann die eindeutige Identifikation zum anderen dazu dienen, auf die dem Bauelement zugeordneten Informationen in einer Datenbank zuzugreifen.

Angaben zu den verwendeten Ausgangsmaterialien können für einzelne oder für alle verwendeten Ausgangsmaterialen erfasst werden. Beispiele für Materialdaten umfassen insbesondere Angaben
- zur Art des jeweils verwendeten Materials,
- zum Hersteller,
- zum Lieferanten,
- zum Lieferdatum,
- zur Charge, und
- zu Fertigungsparametern des Materials.

Angaben betreffend Herstellungsschritte können für einzelne oder für alle durchgeführten Herstellungsschritte erfasst werden. Diese Angaben können insbesondere eine Angabe der Art des durchgeführten Herstellungsschritts und/oder Angaben zu den bei dem Herstellungsschritt verwendeten Parametern umfassen. Beispiele für Informationen betreffend die ausgeführten Herstellungsschritte umfassen insbesondere Angaben
- zur Position des Bauelements oder einer Vorstufe des Bauelements in einem Träger,
- zum eingesetzter Träger bzw. der eingesetzten Werkstückhalterung, insbesondere eine entsprechende Kennung,
- zu den verwendeten Parametern,
- zum Operator bzw. Anlagenführer, und
- zum Zeitpunkt der Bearbeitung.

Angaben zu verwendeten Werkzeugen und Anlagen können für einzelne oder für alle bei der Herstellung eingesetzte Werkzeuge und Anlagen erfasst werden. Beispiele für Informationen betreffend die bei einem Herstellungsschritt verwendeten Werkzeuge und/oder Anlagen umfassen insbesondere
- eine Kennung zur Identifikation des Werkzeugs oder der Anlage, , wie beispielsweise der Temperatur eines Ofens,
- Angaben zu verwendeten Parametern des Werkzeugs oder der Anlage, und
- Angaben zum Zeitpunkt der Bearbeitung.

Beispiele für Informationen betreffend Messungen bzw. Inspektionen umfassen insbesondere
- Angaben zur Art der Messung bzw. Inspektion,
- Angaben zum Zeitpunkt der Messung bzw. Inspektion oder Endkontrolle,
- eine Messgerätekennung bzw. Inspektionsanlagenkennung,
- Angaben zum Inspektionsanlagenoperator und
- das Messergebnis bzw. Inspektionsergebnis.

Somit sind die Informationen, welche einem der beschriebenen Bauelemente zugeordnet sein können, insbesondere ausgewählt aus
- eindeutiger Kennung,
- Materialdaten,
- Position des Bauelements oder einer Vorstufe des Bauelements in einem Träger,
- Operator bzw. Anlagenführer,
- Zeitpunkt der Bearbeitung im Werkzeug und/oder Anlage,
- Werkzeug- und/oder Anlagenidentifikation,
- Werkzeug- und/oder Anlagenparameter,
- Zeitpunkt der Inspektion,
- Inspektionsanlagenkennung,
- Inspektionsergebnis,
- Inspektionsanlagenoperator,
- Inspektionsanlagenparameter,
- Messergebnis,
- Zeitpunkt der Endkontrolle,
- eingesetzter Träger bzw. eingesetzte Werkstückhalterung,
und Kombinationen mehrerer dieser Informationen.

Selbstverständlich ist es aber möglich und denkbar, auch andere Informationen in Zuordnung zu dem Bauelement zu erfassen und mit dem Informationsspeicher zu verknüpfen und/oder in diesem zu speichern. Insbesondere ist es möglich, sämtliche für Dokumentationszwecke oder Beurteilung der Qualität der Bauelemente relevanten Informationen zu erfassen und in dem Informationsspeicher selbst oder in Zuordnung zu dem Informationsspeicher in einer Datenbank zu speichern.

Bevorzugt werden dabei Informationen, welche für eine Vielzahl von Bauelementen identisch sind, nur einmal als Gruppeninformationen in einer Datenbank gespeichert, wobei dann dem Bauelement jeweils ein Verweis auf diese Gruppeninformationen zugeordnet wird.

Dies erlaubt es, die zu speichernde Datenmenge zu reduzieren, indem Informationen, welche jeweils eine Gesamtheit von Bauelementen betreffen, nur ein einziges Mal abgespeichert werden.

Die Gruppeninformationen, auf die die einem Bauteil zugeordneten Informationen verweisen, sind insbesondere ausgewählt aus
- Materialdaten,
- Angaben zum eingesetzter Träger bzw. eingesetzte Werkstückhalterung
- Anlagenführer bzw. Operator für die Gruppe von Bauelementen,
- Zeitpunkt der Gruppenbearbeitung in Anlage und/oder Werkzeug,
- Anlagen- und/oder Werkzeugidentifikation der Gruppenbearbeitung,
- Werkzeug- und/oder Anlagenparameter der Gruppenbearbeitung,
und Kombinationen mehrerer dieser Gruppeninformationen.

Der Informationsspeicher eines Bauelements oder der Ensembleinformationsspeicher eines Behälters ist bevorzugt als eine optisch lesbare Markierung ausgestaltet. Entsprechend ist es bevorzugt, den als eine solche optische Markierung ausgestalteten Informationsspeicher derart außen an dem Bauelement auszubilden, dass dieser für ein optisches Auslesen zugänglich ist. Alternativ oder zusätzlich hierzu ist es denkbar, den Informationsspeicher eines Bauelements oder den Ensembleinformationsspeicher als einen elektronischen Speicher wie einen RFID-Chip oder einen Flashspeicher auszugestalten.

Bevorzugt wird die optisch lesbare Markierung des Bauelements durch einen Bereich des Grundkörpers des Bauelements bereitgestellt, in dem Material des Grundkörpers abgetragen oder eingeprägt ist. Für ein einfaches Auslesen der optisch lesbaren Markierung wird diese bevorzugt auf einer Fläche des Grundkörpers angeordnet, welche bei Weiterverarbeitung zu einer Einheit, beispielsweise zu einer Anzündeeinheit für einen Airbag, nach außen weist.

Alternativ oder zusätzlich dazu kann die optisch lesbare Markierung auf einem der Funktionselemente, insbesondere auf einem Kontaktstift, ausgebildet sein. Die optische Markierung kann dabei beispielsweise als eine Abfolge von Kerben ausgebildet sein.

Die optisch lesbare Markierung ist bevorzugt für ein einfaches maschinelles Auslesen eingerichtet, beispielsweise über ein mit einer Computereinrichtung verbundenes Lesegerät oder die Kamera eines Smartphones. Die optisch lesbare Markierung kann beispielsweise als ein Barcode oder als Matrixcode, insbesondere als ein Data Matrix Code ausgestaltet sein. Denkbar ist aber auch, die optisch lesbare Markierung als alphanumerischen Code auszuführen, der dann mit einer optischen Zeichenerkennung ausgelesen werden kann. Bevorzugt ist die optisch lesbare Markierung dazu eingerichtet, mindestens 20 Zeichen zu speichern.

Die optisch lesbare Markierung weist beispielsweise eine Abmessung von höchstens 1 mm x 3,5 mm auf, insbesondere höchstens 0,8 mm x 3 mm. Durch diese kompakten Abmessungen kann der als optische Markierung ausgebildete Informationsspeicher auch an Bauelementen mit kleinen Abmessungen angeordnet werden und somit auch diese kleinen Bauelemente nachverfolgbar machen.

Der als optisch lesbare Markierung ausgebildete Informationsspeicher kann beispielsweise über ein Lasermaterialbearbeitungsverfahren erhalten werden. Hierzu kann beispielsweise ein entsprechender Laserschritt in ein Verfahren zur Herstellung des Bauelements integriert werden. Weitere Möglichkeiten für das Ausbilden der optisch lesbaren Markierung umfassen insbesondere das Prägen, bei dem einzelne Punkte eines Codes mit einer Nadel geprägt werden, oder das Bedrucken.

Der Ensembleinformationsspeicher eines Behälters kann ebenfalls als eine optisch lesbare Markierung ausgestaltet sein, beispielsweise als Barcode oder als ein Matrixcode wie ein QR-Code oder Data Matrix Code. Alternativ oder zusätzlich hierzu ist es denkbar, den Ensembleinformationsspeicher als RFID-Chip oder als Flashspeicher, beispielsweise in Form eines im Behälter aufgenommenen USB-Stick, auszubilden. Insbesondere bei Ausführung als Flashspeicher kann der Ensembleinformationsspeicher neben einer Kennung, welche den Behälter bzw. das Ensemble identifiziert, auch alle Informationen umfassen, die den Bauelementen des Ensembles zugeordnet sind.

Ein weiterer Aspekt der Erfindung betrifft eine Vorrichtung zur Herstellung der hierin beschriebenen Bauelemente mit zumindest einer elektrischen Durchführung, bei der ein Funktionselement in einer Durchführungsöffnung eines Grundkörpers mittels eines elektrisch isolierenden Materials fixiert ist. Die Vorrichtung umfasst dabei mindestens ein Bearbeitungsmittel zum Versehen der Bauelemente mit einem Informationsspeicher. Ferner ist die Vorrichtung bevorzugt zur Ausführung eines der hierin beschriebenen Verfahren zur Herstellung der Bauelemente ausgebildet. Dazu kann die Vorrichtung zur Herstellung insbesondere eine Steuereinheit mit einer programmierbaren Computereinrichtung umfassen, welche durch Ausführung eines entsprechenden Computerprogramms die entsprechenden Schritte des Herstellungsverfahrens umsetzt.

Wenn der Informationsspeicher der herzustellenden Bauelemente als optisch lesbare Markierung ausgestaltet ist, sind die Bearbeitungsmittel bevorzugt als ein Lasersystem zum Abtragen von Material ausgebildet.

Die Vorrichtung zur Herstellung kann zusätzlich Lesemittel umfassen, um den einmal angeordneten Informationsspeicher während eines oder mehrerer Schritte wieder auszulesen. Wenn der Informationsspeicher als optisch lesbare Markierung ausgebildet ist, sind die Lesemittel bevorzugt als optische Kamera oder Laserscanner ausgebildet. Das entsprechende Lesemittel ist bevorzugt mit einer Steuereinheit der Vorrichtung zur Herstellung verbunden, so dass die in dem Informationsspeicher eines Bauelements enthaltenen Informationen bei nachfolgenden Verfahrensschritten zur Verfügung stehen.

Sind Informationen zum Bauelement in einer Datenbank abgelegt, welche auf einer räumlich getrennten Computereinrichtung bereitgehalten wird, so verfügt die Steuereinheit bevorzugt über eine Kommunikationseinheit zur Verbindung mit einem Datennetzwerk, wie beispielsweise ein lokales Netzwerk oder das Internet, um auf die Datenbank zugreifen zu können.

Ein weiterer Aspekt der Erfindung betrifft eine Vorrichtung zur Weiterverarbeitung der hierin beschriebenen Bauelemente oder eines Ensembles dieser Bauelemente oder von mit einem der hierin beschriebenen Verfahren erhaltenen Bauelementen zu Einheiten, welche jeweils mindestens eines dieser Bauelemente enthalten. Dabei ist vorgesehen, dass die Vorrichtung Lesemittel zum Auslesen des Informationsspeichers der Bauelemente oder des Ensembleinformationsspeichers eines Behälters mit den Bauelementen umfasst. Ferner ist die Vorrichtung bevorzugt zur Ausführung eines der hierin beschriebenen Verfahren zur Weiterverarbeitung ausgebildet. Dazu kann die Vorrichtung zur Weiterverarbeitung insbesondere eine Steuereinheit mit einer programmierbaren Computereinrichtung umfassen, welche durch Ausführung eines entsprechenden Computerprogramms die entsprechenden Schritte des Weiterverarbeitungsverfahrens umsetzt.

Wenn der Informationsspeicher als optisch lesbare Markierung ausgebildet ist, sind die Lesemittel bevorzugt als optische Kamera oder Laserscanner ausgebildet. Das entsprechende Lesemittel ist bevorzugt mit einer Steuereinheit der Vorrichtung zur Weiterverarbeitung verbunden, so dass die in dem Informationsspeicher eines Bauelements enthaltenen Informationen bei der Weiterverarbeitung zur Verfügung stehen. Sind Informationen zum Bauelement in einer Datenbank abgelegt, welche auf einer räumlich getrennten Computereinrichtung bereitgehalten wird, so verfügt die Steuereinheit bevorzugt über eine Kommunikationseinheit zur Verbindung mit einem Datennetzwerk, wie beispielsweise ein lokales Netzwerk oder das Internet, um auf die Datenbank zugreifen zu können.

Erfindungsgemäß wird auch ein System bereitgestellt, mit dem Informationen, welche einem Bauelement zugeordnet wurden, einem Weiterverarbeiter zugänglich gemacht werden können. Das System umfasst eine Computereinrichtung und ein damit verbundenes Lesegerät zum Auslesen des Informationsspeichers des Bauelements. Das System ist bevorzugt dazu eingerichtet zumindest eine Information zu einer messbaren Eigenschaft des Bauelements aus dem Informationsspeicher auszulesen.

Alternativ oder zusätzlich dazu ist das System dazu eingerichtet, eine in dem Informationsspeicher des Bauelements kodierte eindeutige Kennung auszulesen System oder unter Verwendung der eindeutigen Kennung zumindest eine Information zu einer messbaren Eigenschaft des Bauelements aus einer Datenbank unter Verwendung der eindeutigen Kennung abzurufen. Die Datenbank kann in der Computereinrichtung des Systems abgelegt sein oder auf einem Server vorgehalten werden. In diesem Fall verfügt das System bevorzugt über Kommunikationsmittel, um mit dem Server zu kommunizieren. Die Kommunikationsmittel sind dabei insbesondere für eine Verbindung mit einem Datennetzwerk wie dem Internet eingerichtet. Das vorgeschlagene System kann somit räumlich getrennt von dem Standort der Datenbank verwendet werden.

Das System kann über Messmittel verfügen, um die messbare Eigenschaft des Bauelements zu messen. Ferner kann das System Vergleichsmittel umfassen, um diese Messung mit der unter Verwendung des Informationsspeichers erhaltenen Information zu vergleichen. Dabei können für den Vergleich Sollwerte oder Grenzwerte vorgegeben werden, so dass die Vergleichsmittel insbesondere bestimmen können, ob ein Bauelement die vorgegebenen Sollwerte bzw. Grenzwerte einhält. Somit ist das vorgeschlagene System insbesondere zur Durchführung einer Qualitätskontrolle der Bauelemente geeignet. Hierzu kann das vorgeschlagene System beispielsweise bei einem Weiterverarbeiter der Bauelemente installiert und für eine Eingangskontrolle der Bauelemente verwendet werden.

Das beschriebene Bauelement bzw. das mit einem der beschriebenen Verfahren erhaltene Bauelement wird bevorzugt in einer Anzündeeinheit für Airbags oder einem Anzünder für Gurtstraffer verwendet.

Für den Einsatz in Anzündeeinheiten für Airbags weist ein Grundkörper des Bauelements bevorzugt eine Dicke zwischen 1 mm und 5 mm, bevorzugt 2 mm bis 4.2 mm auf. Die Durchgangsöffnung für die Aufnahme eines Metallstifts als Funktionselement weist bevorzugt einen kreisrunden oder ovalen Querschnitt auf, wobei der Durchmesser des Metallstiftes beispielsweise 0,8 bis 1,2 mm beträgt und die Durchmesser der Durchgangsöffnung beispielsweise im Bereich von 1,6 mm bis 3,0 mm liegt.

Bevorzugt werden für das Bauteil bzw. für dessen Vorstufen Toleranzen festgelegt, welche in einem Inspektionsschritt überprüft werden können. Beispielsweise kann im Fall einer Anzündeeinheit für Airbags für den Durchmesser des Grundkörpers die zulässige Toleranz im Bereich von +/-0,02mm - +/-0,04mmvorgegeben werden. Bei einem Inspektionsschritt kann dann tatsächlichen Toleranzen erfasst und dem Bauteil zugeordnet werden. Das Ergebnis der Inspektion kann dann dem Bauteil als Information zugeordnet werden. Des Weiteren ist ein Einordnen der Bauteile in verschiedene Qualitätsklassen möglich. Bei bestimmten Abmessungen lässt sich das Toleranzfeld bestimmten Werkzeugen zuordnen und, sofern zulässige Toleranzen überschritten werden, kann eine gezielte Korrektur durchgeführt werden, beispielsweise durch Austauschen des Werkzeugs.

Dieses Vorgehen lässt sich für eine Vielzahl von Abmessungen und anderen messbaren Parametern an dem Bauteil durchführen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungen und Ausführungsformen der Erfindung sind in den Zeichnungen dargestellt und werden in der nachfolgenden Beschreibung näher erläutert, wobei sich gleiche Bezugszeichen auf gleiche oder ähnliche oder funktional gleiche Bauelemente oder Elemente beziehen.

Dabei zeigen in schematischer Form
Fig. 1 Schritte eines Verfahrens zur Herstellung von Bauelementen gemäß einer Ausführungsform der vorliegenden Erfindung;
Fig. 2 Schritte eines Verfahrens zur Weiterverarbeitung gemäß einer Ausführungsform der vorliegenden Erfindung;
Fig. 3 Schritte eines Verfahrens gemäß einer Ausführungsform der vorliegenden Erfindung;
Fig. 4 Schritte eines Verfahrens gemäß einer Ausführungsform der vorliegenden Erfindung; und
Fig. 5a, 5b und 5c Ausführungsbeispiele für Bauelemente mit einem Informationsspeicher gemäß der vorliegenden Erfindung.

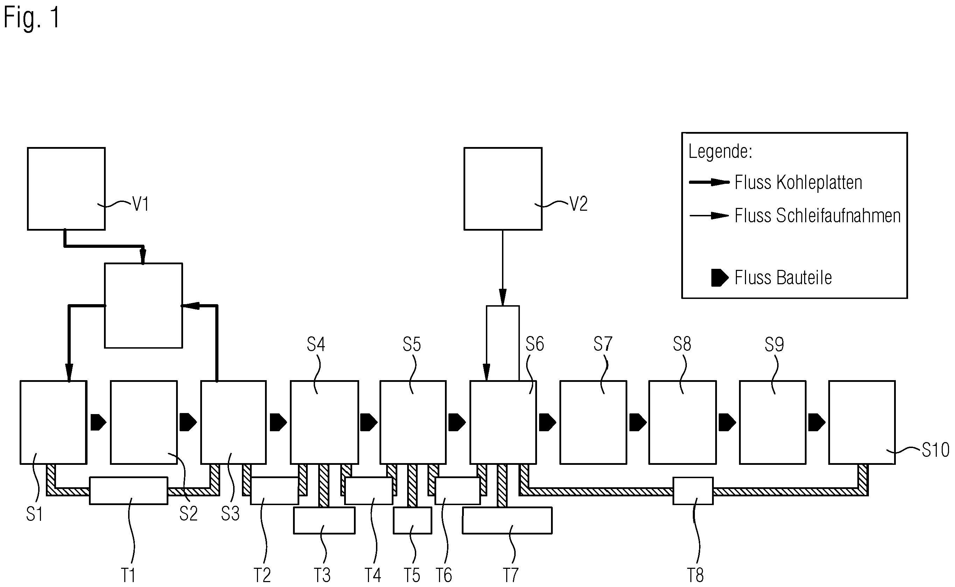

Figur 1 zeigt Schritte eines vorteilhaften Verfahrens zur Herstellung von Bauelementen gemäß einer Ausführungsform der vorliegenden Erfindung am Beispiel der Herstellung eines Bauelements für einen Anzünder für Personenrückhaltesysteme in Form von Airbags.

Hierzu werden zunächst entsprechende Formen zur Herstellung einer Vielzahl von Durchführungen für Anzünder bereitgestellt, beispielsweise in Form von Kohleformen, die mit entsprechenden Materialien zur Herstellung von Durchführungen versehen werden (Schritt S1: Montage). Jede der Kohleformen weist dabei eine Vielzahl von Aufnahmen auf, wobei in jeder Aufnahme eine Durchführung montiert werden kann. Entsprechend umfasst der Schritt S1 in diesem Beispiel, dass in jede der Aufnahmen ein Grundkörper, auch Header genannt, ein Rohling für das elektrisch isolierende Material, und ein Anschlussstift montiert werden.

Für den Montageschritt S1 wird eine Kohleform als Bauelementeträger bereitgestellt, wobei die verwendete Kohleform über eine Bauelementeträgerkennung identifiziert wird. Die Bauelementeträgerkennung wird beispielsweise in einem an der Kohleform angeordneten Informationsspeicher, beispielsweise eine optisch lesbare Markierung, gespeichert. Die optisch lesbare Markierung ist beispielsweise als ein Data Matrix Code ausgeführt. Da der später ausgeführte Schmelzschritt S2 bei erhöhten Temperatur ausgeführt wird, wird der Matrixcode auf der jeweiligen Kohleform bevorzugt resistent gegen die dabei auftretenden thermischen Belastungen ausgeführt. Neue Kohleformen werden in einem Schritt V1 bereitgestellt, mit einem Informationsspeicher versehen und registriert. Bereits einmal verwendete Kohleformen können wiederverwertet werden und werden dabei über den bereits vorhandenen Informationsspeicher bzw. die darin abgelegte Bauelementeträgerkennung identifiziert. In dem Ablaufdiagramm der Figur 1 wird der Fluss der Kohleformen über mit Pfeilen versehene Linien mittlerer Stärke gekennzeichnet.

In dem Informationsspeicher der Kohleform oder in einer zugeordneten Datenbank können im Rahmen des Verfahrens weitere Angaben zu der Kohleform hinterlegt werden. Diese Angaben können beispielsweise der Typ der Kohleform, Angaben zum Material, Anzahl der bisherigen Einsätze und dergleichen mehr umfassen.

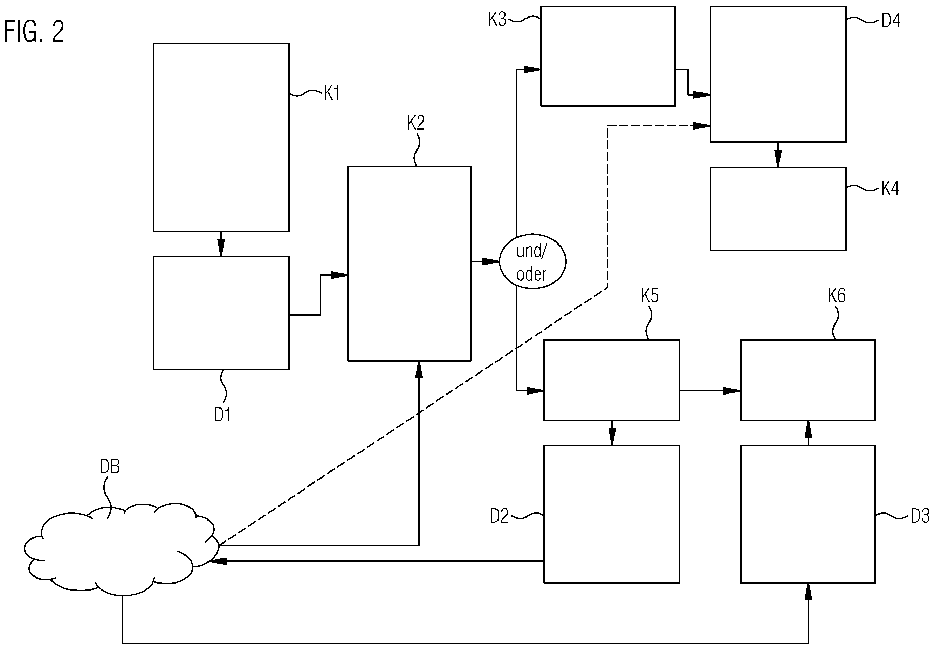

Informationen betreffend die Vorstufen des herzustellenden Headers werden dem herzustellenden Header bereits im Montageschritt S1 zugeordnet, wobei der jeweilige Header bzw. dessen Vorstufe über die entsprechende Aufnahme der Kohleform und deren Bauelementeträgerkennung identifiziert wird. Bei dem Schritt S1 sind die Informationen beispielsweise ausgewählt aus Angaben zum Montageteam, der Losnummer der eingesetzten Ausgangsmaterialen bzw. Vorstufen für die Header, verwendete Metalle für die Vorstufen der Bauelemente, insbesondere Hersteller, Charge und Typ, Geometrie der Header bzw. der Vorstufen, der Montagezeitpunkt und Parameter für die Montage. Diese Daten werden beispielsweise in Datensätzen der jeweiligen Header in einer Datenbank DB (siehe Fig. 2) hinterlegt.

Nach dem Montageschritt S1 werden die elektrischen Durchführungen in einem Schmelzschritt S2 in einem Ofen erzeugt, wobei den einzelnen Bauelementen bzw. deren Vorstufen die für den Schmelzschritt S2 relevanten Informationen zugeordnet werden. In dem Ablaufdiagramm der Figur 1 wird der Fluss der Bauteile über dicke Pfeile gekennzeichnet.

Solange dabei die Header bzw. deren Vorstufen noch nicht über einen Informationsspeicher verfügen, werden diese über die jeweilige Kohleform und deren Position innerhalb dieser Kohleform eindeutig identifiziert und nachverfolgt, welche als ein erster Informationsträger T1 in dem Verfahren dient. Dazu wird in dem dargestellten Beispiel des Verfahrens zur Herstellung der Informationsspeicher der Kohleformen ausgelesen und die darin gespeicherte Bauelementeträgerkennung gelesen. Die verwendeten Prozessparameter des Schmelzschritts, wie beispielsweise eine Kennung des Ofens, Zeitpunkt der Ausführung, Temperatur, Dauer, Position der Kohleform im Ofen und/oder Bediener des Ofens, werden dann allen in der jeweiligen Kohleform aufgenommenen Header bzw. deren Vorstufen zugeordnet.

Nach dem Schmelzen in dem Schritt S2 werden die Bauelemente aus ihren bisherigen Bauelementeträgern entnommen und für einen Transport zum nächsten Herstellungsschritt umverpackt. Dazu erfolgt eine Vereinzelung/Demontage der Bauelemente, hier der Header, und in dem Schritt S3 werden diese in ein Transportbehältnis für den Weitertransport zum nächsten Herstellungsschritt gefüllt. Das Transportbehältnis als neuer Bauelemeneträger wird in dem vorliegenden Beispiel ebenfalls mit einem Informationsspeicher versehen und dient als ein zweiter Informationsträger T2. Der Informationsspeicher enthält insbesondere wieder eine individuelle Bauelementeträgerkennung des Transportbehältnisses. Zusätzlich können in dem Informationsspeicher selbst oder in einer zugeordneten Datenbank die Daten, die auf der Kohleform aufgebracht waren oder dergleichen gespeichert werden. Der Informationsspeicher des Transportbehältnisses kann dabei beispielsweise in Form eines Labels mit optisch lesbarer Markierung, eines RFID-Tags oder dergleichen ausgeführt werden. Informationen betreffend die jeweiligen Anzünder können jeweils durch einen Datensatz in einer Datenbank repräsentiert werden und mit dem jeweiligen ID Code des Transportbehältnisses verknüpft werden. Ebenso können beispielsweise die Daten wie Demontagezeitpunkt, Demontageteam, Position des Headers in der Kohleform, Zustandsparameter der Kohleform, insbesondere deren Oxidationslevel, Kennung des Headers oder dergleichen dann in den jeweiligen Datensätzen der jeweiligen Header in der Datenbank hinterlegt werden.

Über die Bauelementeträgerkennung und eine Angabe darüber, welches Bauelement sich an welcher Position in dem Bauelementeträger befindet, kann das Bauelement bzw. dessen Vorstufe auch nach dem Umverpacken nachverfolgt werden. Bevorzugt ist jedoch vorgesehen, die Header bzw. deren Vorstufen nach dem Schmelzschritt S2 und vor dem Vereinzeln und Umverpacken gemäß Schritt S3 mit einem individuellen Informationsspeicher zu versehen. In diesem Beispiel ist der Informationsspeicher der Anzünder als eine optisch lesbare Markierung in Form eines Data Matrix Codes ausgeführt, welche eine individuelle Kennung des entsprechenden Headers kodiert.

Die Markierung der Header zum Aufbringen des als Data Matrix Codes ausgebildeten Informationsspeichers erfolgt insbesondere durch eine Lasergravur, vorzugsweise direkt nach dem Schmelzprozess, da die Grundkörper bzw. Header der Anzünder hier vereinzelt und gerichtet in den Kohleformen liegen. Die optisch lesbare Markierung mit dem individuelle ID Code bzw. die eindeutige Kennung auf dem jeweiligen Header ist dabei resistent gegen Chemikalien der nachfolgenden Bearbeitungsschritte und weist eine bestimmte Fläche bspw. 1,5 mm x 5 mm, vorzugsweise 0,8 mm x 3 mm auf.

Mittels des Transportbehältnisses als Träger für die Bauelemente, welches selbst beschriftet ist und als zweiter Informationsträger T2 dient und so eine Identifizierung ermöglicht, werden die vereinzelten Header nun weiter transportiert und dann in einem weiteren Schritt S4 gebeizt und in einem weiteren Schritt S5 vergoldet. Die einzelnen Bauelemente verfügen zwar bereits über einen individuellen Informationsspeicher, der eine eindeutige Identifizierung ermöglicht. Das Einlesen eines einzigen Informationsspeichers des Transportbehältnisses vor dem Ausführen des nächsten Schrittes S4 wird hier jedoch bevorzugt, da in diesem Fall nur ein einziger Informationsspeicher ausgelesen werden muss, um für ausgeführten Schritt, hier der Schritt S4, relevante Informationen allen in dem Transportbehältnis aufgenommenen Bauelementen auf einmal zuzuordnen.

Beim Reinigen in Schritt S4 werden Trommeln verwendet, deren jeweilige Nummer während der Ausführung dieses Herstellungsschrittes als Identifizierung bzw. Informationsträger für die bearbeiteten Bauelemente dient (Bezugszeichen T3) und bei der Weiterarbeitung vermerkt wird. Ebenso können entsprechende Parameter des Prozessschrittes "Reinigen" vermerkt werden, beispielsweise Start- und Endzeitpunkt des Reinigens, Reinigungslinie, Reinigungstrommel, Anlagenbediener und Anlagenparameter. Beim Vergolden in Schritt S5 können ebenfalls entsprechende Parameter des Prozessschrittes "Vergolden" vermerkt werden, d.h. in dem Datensatz des Anzünders in der Datenbank entsprechend hinterlegt werden, beispielsweise Start- und Endzeitpunkt des Vergoldens, Vergoldungslinie, Anlagenbediener und Anlagenparameter. Hierbei dient wieder ein beschriftetes Transportbehältnis zum Transport zwischen der entsprechenden Beiz- und der Vergoldungseinrichtung als vierter Informationsträger T4. Während des Schritts S5 dient der auf dem jeweiligen Header aufgebrachte ID Code als fünfter Informationsträger T5.

Nach dem Schritt S5 - Vergolden - werden die Bauelemente - hier die vergoldeten Header - mittels eines Transportbehältnisses nun zum Schleifen weiter transportiert. Dabei wird das Transportbehältnis wieder individuell gekennzeichnet und dient als sechster Informationsträger T6 und diese Kennzeichnung kann dann wieder den Datensätzen der jeweiligen Header in einer Datenbank anhand des ID Codes der jeweiligen Bauelemente zugewiesen werden.

In einem weiteren optionalen Schritt S6 werden die Header nun geschliffen. Neu bereitgestellte Schleifaufnahmen als Bauelementeträger werden in einem Schritt V2 mit einem Informationsspeicher versehen, der wiederum eine eindeutige Kennung der jeweiligen Schleifaufnahme enthält. Der Informationsspeicher ist beispielsweise wieder als eine optisch lesbare Markierung in Form eines Data Matrix Codes ausgeführt. Vor der Verwendung einer neuen oder wiederverwerteten Schleifaufnahme für den Schleifschritt S6 wird deren Kennung durch Auslesen des Informationsspeichers ausgelesen. Der Fluss der Schleifaufnahmen wird in dem Ablaufdiagramm der Figur 1 über mit Pfeilen versehene dünne Linien gekennzeichnet.

Solange sich die Header bzw. deren Vorstufen in einer Schleifaufnahme befinden, kann diese als Informationsträger T7 dienen, wobei die einzelnen Header über die Kennung der Schleifaufnahme und deren Position innerhalb der Schleifaufnahme identifiziert werden.

Die jeweilige Schleifaufnahme betreffende Daten können dann in Zuordnung zu dieser Kennung in einer Datenbank hinterlegt werden und auch in den jeweiligen Datensätzen der Header, welche in der jeweiligen Schleifaufnahme bearbeitet wurden, in der Datenbank DB hinterlegt werden. Die bei dem Schleifschritt S6 in Zuordnung zu einem Bauelement erfassten Angaben umfassen beispielsweise Zeitpunkt des Schleifens, Schleifmaschine, Schleifaufnahme, Bedienerteam, Anlagenparameter, oder dergleichen.

Nach dem Schleifen S6 werden die geschliffenen Header in einem weiteren Schritt S7 einer individuellen Kontrolle unterzogen, wobei ab der Entnahme der Header aus der Schleifaufnahme wieder der Informationsspeicher der Bauelemente bzw. Header als achter Informationsträger T8 dient. Bei dieser Kontrolle werden beispielsweise die Header einem Funktionstest unterzogen und der Zeitpunkt der Kontrolle, die Kontrollanlagennummer, die Prüfergebnisse eines jeden Headers, Anlagenbediener und Anlagenparameter festgestellt. Weiterhin können die Güte des Headers und/oder die Maßhaltigkeit/Bemaßung festgestellt werden. Die vorgenannten Daten und Parameter können dann wieder dem Datensatz des jeweils kontrollierten Headers anhand dessen eindeutiger Kennung bzw. ID Code hinzugefügt werden. Danach werden die Header sortiert (Schritt S8) und einer Endkontrolle (Schritt S9) unterzogen. Hier kann alternativ zu der Kontrolle in Schritt S7 oder zusätzlich die Güte des Headers und/oder die Maßhaltigkeit/Bemaßung festgestellt und neben weiteren Daten wie Zeitpunkt der Endkontrolle und Prüfer diese wieder dem Datensatz des jeweils kontrollierten Headers anhand dessen ID Code hinzugefügt werden. Optional kann die Kommissionierung anhand Vorgaben von Kunden durchgeführt werden. Anschließend erfolgt das Verpackung und der Versand an einen Weiterverarbeiter in einem weiteren Schritt S10.

Somit ist von der Montage bis zum Versand der Header eine hohe und anpassbare Transparenz des Fertigungsprozesses jedes einzelnen Headers möglich. Entsprechende Daten sind für jeden Header individuell in der Datenbank hinterlegt und zur Optimierung von Prozessen, Analysen, Feststellung von Ursachen von Produktionsfehlern oder dergleichen verfügbar. Insbesondere sind bei einer Analyse der Daten der Kohleformen und/oder der Schleifaufnahmen Verschleißerscheinungen frühzeitig erkennbar, so dass die entsprechenden Aufnahmen und Formen rechtzeitig ausgewechselt werden können, was den Ausschuss senkt. Daneben können Korrelationen in den hinterlegten Informationen erkannt werden, beispielsweise mittels neuronaler Netze oder dergleichen und so die Produktion durch Anpassung von Material und/oder Prozessparametern verbessert bzw. optimiert werden.

Figur 2 zeigt Schritte eines Verfahrens zur Weiterverarbeitung von Bauelementen gemäß einer Ausführungsform der vorliegenden Erfindung am Beispiel der Weiterverarbeitung von Header von Anzündern für Airbags.

Im Detail zeigt das Beispiel der Figur 2 Verfahrensschritte, die von einem Weiterverarbeiter als Kunden des Herstellers der Anzünder bei Empfang der Anzünder durchgeführt werden.

In einem ersten Schritt K1 wird eine Eingangskontrolle durchgeführt. Hierbei erfolgt ein Scannen einer Kontrollgruppe von Headern zum Auslesen des an diesen angebrachten Data Matrix Codes und ein Erfassen der individuellen Kennungen bzw. ID Codes der Header. Des Weiteren erfolgt ein Vermessen der individuellen Header. Im Anschluss daran wird in einem weiteren Schritt D1 ein neuer Datensatz vom Weiterverarbeiter erzeugt, der Daten über die Maßhaltigkeit/Bemaßung der Header der Kontrollgruppe aufweist. Anhand der individuellen ID Codes der Header fordert der Weiterverarbeiter von der Datenbank DB des Herstellers der Bauelemente entsprechende Daten der Header an. Anhand dieser Daten führt der Weiterverarbeiter in einem Schritt K2 einen Vergleich durch: Er vergleicht hierbei seine in Schritt K1 erhaltenen Messergebnisse mit denen aus der Datenbank DB des Herstellers der Header.

Der Weiterverarbeiter hat nun zwei Möglichkeiten: Der Weiterverarbeiter kann einerseits in einem Schritt K3 entscheiden, dass die Maßhaltigkeit auf Basis des in Schritt K2 durchgeführten Vergleichs seinen Anforderungen genügt. In einem weiteren Schritt K4 führt er dann die Weiterverarbeitung aller erhaltenen Header durch. Zuvor fragt der Weiterverarbeiter anhand der individuellen ID Codes aller erhaltenen Header von der Datenbank DB des Herstellers entsprechende Daten der Zünder ab (Schritt D4). Die erhaltenen Daten des Herstellers nutzt dann der Weiterverarbeiter für die Steuerung seiner Weiterverarbeitung.

Alternativ oder zusätzlich kann der Weiterverarbeiter andererseits anhand des Vergleichs in Schritt K2 einen individuellen Korrekturfaktor für jeden Header oder einen gemittelten Korrekturfaktor für eine Gruppe von Headern oder alle Header in einem Schritt K5 bestimmen. Hierzu erzeugt der Weiterverarbeiter jeweils einen neuen Datensatz (Schritt D2), der die entsprechenden Abweichungen oder den jeweiligen Korrekturfaktor allgemein oder individuell für jeden Header enthält. In einem weiteren Schritt K6 führt er dann die Weiterverarbeitung aller erhaltenen Header unter Berücksichtigung des jeweiligen oder allgemeinen Korrekturfaktors durch. Zuvor fragt der Weiterverarbeiter anhand der individuellen ID Codes aller erhaltenen Header von der Datenbank DB des Herstellers entsprechende Daten der Header ab (Schritt D3). Die erhaltenen Daten des Herstellers nutzt dann der Weiterverarbeiter zusammen mit seinen eigenen erhaltenen Datensätzen der Schritte D1 und D2 für die Steuerung seiner Weiterverarbeitung.

Des Weiteren kann der Weiterverarbeiter die Kennungen der Bauelemente zur Nachverfolgung dieser Bauelemente in den erhaltenen Einheiten nutzen. Dazu kann beispielsweise ein neuer Datensatz betreffend jede einzelne Einheit erzeugt werden, in den die vom Hersteller der Bauelemente zu diesem Bauelement erfassten Daten einkopiert werden. Für eine eindeutige Identifikation der Datensätze kann die Einheit wiederum mit einer eindeutigen Kennung versehen werden oder, falls der am Bauelement angeordnete Informationsspeicher nach der Weiterverarbeitung noch zugänglich und lesbar ist, eine in dem Informationsspeicher des Bauelements vorhandene Kennung weitergenutzt werden.

Der Weiterverarbeiter kann dadurch in diesem Beispiel genau nachverfolgen, welcher Anzünder in welcher Einheit verbaut wurde und welche Eigenschaften der verbaute Anzünder hat. Im Fall des Fehlers einer Einheit kann somit die gesamte Produktionskette bis zu den Vorprodukten des in der Einheit verbauten Bauelements nachvollzogen werden. Dies erlaubt es insbesondere durch Auswerten der in der Datenbank abgelegten Informationen weitere Bauelemente und entsprechend die erzeugten Einheiten zu identifizieren, welche gegebenenfalls ebenfalls von einem Qualitätsproblem betroffen sein können, ohne von vornherein alle Bauelemente bzw. erzeugten Einheiten einer Charge verwerfen zu müssen.

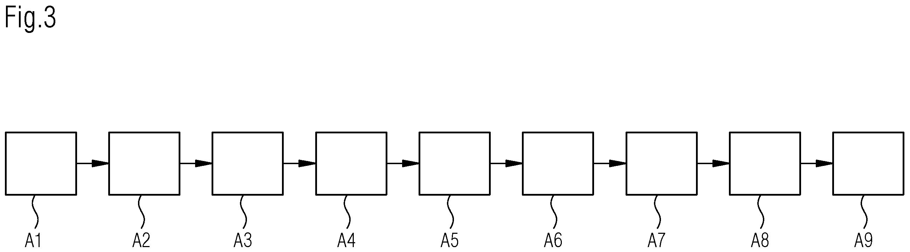

Figur 3 zeigt schematisch das Optimieren eines Verfahren zur Herstellung von Bauelementen unter Verwendung von bauelementspezifischen Informationen gemäß einer Ausführungsform der vorliegenden Erfindung am Beispiel von Bauelementen zum Einsatz in Personenrückhaltesystemen oder dergleichen.

In einem ersten Schritt A1 erfolgt ein Ermitteln von Materialdaten der zur Herstellung der Bauelemente bereitgestellten Vorstufen bzw. Materialien.

In einem weiteren Schritt A2 erfolgt ein Ermitteln von zumindest einem Herstellungsprozessparameter für einen Herstellungsprozess zur Herstellung der Bau-elemente.

In einem weiteren Schritt A3 erfolgt ein Herstellen der Bauelemente anhand eines Herstellungsprozesses mit den ermittelten Prozessparametern.

In einem weiteren Schritt A4 erfolgt ein Bereitstellen eines individuellen Identifikationsmerkmals für jedes Bauelement in Form einer eindeutigen Kennung.

In einem weiteren Schritt A5 erfolgt ein Anordnen eines Informationsspeichers an jedem der hergestellten Bauelemente, wobei das bereitgestellte Identifikationsmerkmal in dem Informationsspeicher abgelegt wird.

In einem weiteren Schritt A6 erfolgt ein Speichern der bauelementspezifischen Materialdaten und der Herstellungsprozessparameter in einer Datenbank einer Computereinrichtung, wobei das Identifikationsmerkmal den entsprechenden Datensatz in der Datenbank identifiziert.

In einem weiteren Schritt A7 erfolgt ein Ermitteln eines Zustands zumindest eines der hergestellten Bauelemente, wobei das Bauelement über das Identifikationsmerkmal identifiziert wird und das Ergebnis der Ermittlung in Zuordnung zu diesem Bauelement in der Datenbank abgelegt wird.

In einem weiteren Schritt A8 erfolgt ein Vergleichen des ermittelten Zustands des Bauelements mit vorgegebenen Sollwerten. Dabei werden Bauelemente ermittelt, welche Grenzwertüberschreitungen bzw. Grenzwertunterschreitungen aufweisen.

Im Schritt A9 werden aus der Datenbank für die ermittelten Bauelemente mit Grenzwertüberschreitungen bzw. Grenzwertunterschreitungen die diesen zugeordneten Informationen aus der Datenbank abgerufen und analysiert. Dabei werden gemeinsame Ursachen für die Abweichungen von den vorgegebenen Sollwerten identifiziert und die Ergebnisse beispielsweise in Form geänderter Parameter oder einer Anweisung, ein Werkzeug oder einen Bauelementeträger auszutauschen als Feedback zurück in das Verfahren gegeben, um die Herstellung der Bauelemente zu optimieren.

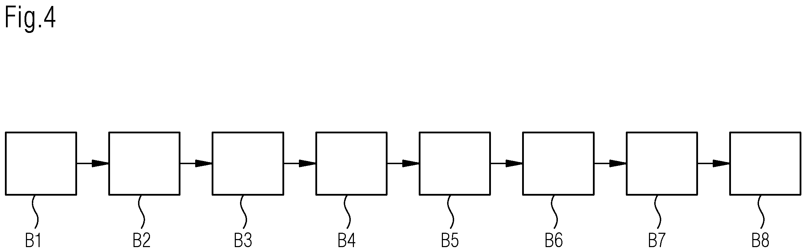

Figur 4 zeigt schematisch das Bereitstellen von Informationen in einem Verfahren zum Weiterverarbeiten einer Mehrzahl von Bauelementen.

In einem ersten Schritt B1 erfolgt ein Zusammenfassen einer Anzahl von Bauelementen zu einer Gruppe.

In einem weiteren Schritt B2 erfolgt ein Identifizieren eines jeden Bauelements der Gruppe anhand seines individuellen Identifikationsmerkmals, welches beispielsweise aus einem Informationsspeicher des Bauelements ausgelesen wird.

In einem weiteren Schritt B3 erfolgt ein Messen jedes identifizierten Bauelementes der Gruppe zumindest hinsichtlich einer individuellen Zustandsprüfinformation.

In einem weiteren Schritt B4 erfolgt ein Anfordern zumindest der individuellen Zustandsprüfinformation für das jeweilige Bauelement aus der Datenbank des Herstellers des Bauelements.

In einem weiteren Schritt B5 erfolgt ein Empfangen zumindest der individuellen Zustandsprüfinformation für das jeweilige Bauelement.

In einem weiteren Schritt B6 erfolgt ein Ermitteln von Abweichungen zwischen zumindest den gemessenen Zustandsprüfinformationen und den empfangenen Zustandsprüfinformationen.

In einem weiteren Schritt B7 erfolgt ein Ermitteln von einem oder mehreren Korrekturparametern auf Basis der ermittelten Abweichungen individuell für jedes Bauelement und in einem weiteren Schritt B8 erfolgt ein Weiterverarbeiten des jeweiligen Bauelements ohne oder mit zumindest teilweiser Berücksichtigung der ermittelten Korrekturparameter.

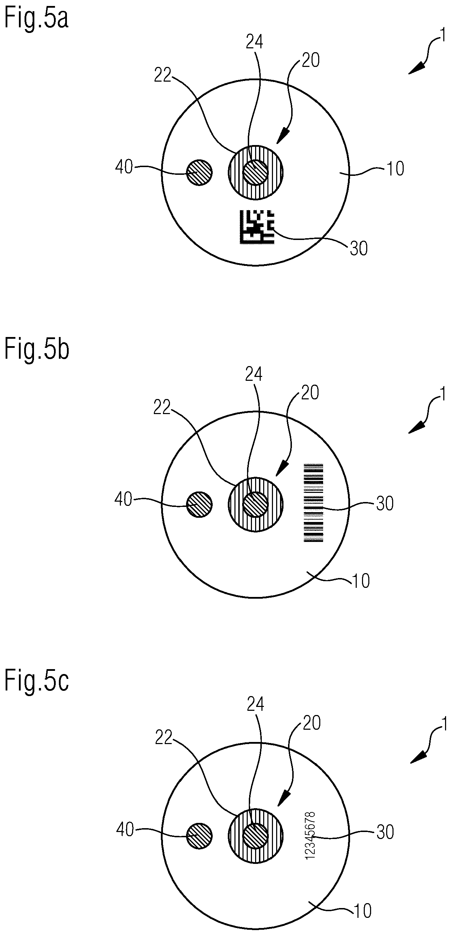

Die Figuren 5a, 5b und 5c zeigen jeweils ein Beispiel für ein Bauelement mit einem Informationsspeicher gemäß der vorliegenden Erfindung.

In den drei dargestellten Ausführungsbeispielen umfasst das Bauelement 1 jeweils einen Grundkörper 10, in dem eine elektrische Durchführung 20 angeordnet ist. Die elektrische Durchführung 20 ist in einer Durchgangsöffnung des Grundkörpers 10 angeordnet und weist einen ersten Metallstift 24 auf, der mit einem elektrisch isolierenden Material 22 gehalten wird. In den dargestellten Beispielen ist des Weiteren ein zweiter Metallstift 40 elektrisch mit dem Grundkörper 10 verbunden. Der erste Metallstift 24 dient in einer Einheit, welche das Bauelement 1 enthält, beispielsweise als Signalanschluss und der zweite Metallstift 40 dient beispielsweise als Masseanschluss.

Erfindungsgemäß weisen die beispielhaft dargestellten Bauelemente 1 jeweils einen Informationsspeicher in Form einer optisch lesbaren Markierung 30 auf.

In dem ersten Ausführungsbeispiel der Figur 5a ist die optisch lesbare Markierung 30 als ein Matrixcode ausgestaltet und derart am Grundkörper 10 angeordnet, dass der erste Metallstift 24, der zweite Metallstift 40 und die optisch lesbare Markierung 30 einen Winkel bilden.

In dem zweiten Ausführungsbeispiel der Figur 5b und dem dritten Ausführungsbeispiel der Figur 5c sind der erste Metallstift 24, der zweite Metallstift 40 und die optisch lesbare Markierung 30 auf einer Linie angeordnet. Im zweiten Ausführungsbeispiel ist die optisch lesbare Markierung 30 dabei als Barcode ausgestaltet und im dritten Ausführungsbeispiel ist die optisch lesbare Markierung 30 als alphanumerischer Code ausgeführt, welcher beispielsweise mittels optischer Zeichenerkennung maschinell lesbar ist.

Zumindest eine der Ausführungsformen der Erfindung weist zumindest einen der folgenden Vorteile auf:
- Zuordnung von wesentlichen Parametern des jeweiligen Bauelements bereits vor der Herstellung demselben.
- Individuelle Hinterlegung der wesentlichen Parameter anhand der jeweiligen Kennung in einer Datenbank.
- Einfache Bereitstellung einer Vielzahl für die Herstellung, Produktion und Weiterverarbeitung des Bauelements relevanten Parameter.
- Einfache, schnellere und effizientere Fehlersuche in der Produktionskette bei als defekt erkannten Bauelementen.
- Engmaschige Überwachung der Produktion.
- Schnellere Erkennung und Aussortierung fehlerhafter Bauelemente ggf. noch vor der Auslieferung an Kunden bzw. Weiterverarbeiter.
- Verringerter Ausschuss bei der Produktion.
- Höhere Qualität der Bauelemente insgesamt.
- Bereitstellung ausgewählter Daten individuell für jedes bezogene Bauelement für Weiterverarbeiter bzw. Kunden, sodass deren Eingangskontrolle ganz oder zumindest teilweise entfallen kann, was Zeit und Kosten bei Kunden spart.

Obwohl die vorliegende Erfindung anhand bevorzugter Ausführungsbeispiele beschrieben wurde, ist sie nicht darauf beschränkt, sondern auf vielfältige Weise modifizierbar.

### Bezugszeichenliste

- DB: Datenbank
- A1-A9: Verfahrensschritte
- B1-B8: Verfahrensschritte
- D1-D4: Datensatzverfahrensschritte
- K1-K6: Prozessschritte Kunde
- S1-S10: Verfahrensschritte Herstellung
- T1-T8: Information
- V1, V2: Registrierungsschritte
- 1: Bauelement
- 10: Grundkörper
- 20: elektrische Durchführung
- 22: isolierendes Material
- 24: erster Metallstift
- 30: optisch lesbare Markierung
- 40: zweiter Metallstift

## Patentansprüche

1. Verfahren zur Herstellung einer Vielzahl von Bauelementen mit zumindest einer elektrischen Durchführung, bei der ein Funktionselement in einer Durchführungsöffnung eines Grundkörpers mittels eines elektrisch isolierenden Materials fixiert ist, wobei Informationen in Zuordnung zu jedem der Bauelemente erfasst werden, **dadurch gekennzeichnet, dass** in einem der Herstellungsschritte des Verfahrens jedes Bauelement oder eine der Vorstufen jedes Bauelements mit einem Informationsspeicher versehen wird, wobei die Informationen in dem Informationsspeicher abgelegt werden und/oder in dem Informationsspeicher eine Kennung abgelegt wird und die Informationen in Zuordnung zu dieser Kennung in einer Datenbank hinterlegt werden.

2. Verfahren zur Herstellung nach Anspruch 1, **dadurch gekennzeichnet, dass** die Informationen ausgewählt sind aus einem oder mehreren aus der Gruppe von Informationen betreffend verwendete Ausgangsmaterialien, Informationen betreffend ausgeführte Herstellungsschritte, Informationen betreffend verwendete Werkzeugen und Anlagen, Informationen betreffend Messungen und einer eindeutigen Kennung.

3. Verfahren zur Herstellung nach Anspruch 1 oder 2, **dadurch gekennzeichnet, dass** jedes Bauelement oder eine Vorstufe jedes Bauelements in zumindest einem Herstellungsschritt eindeutig identifiziert wird über seine Lage in einem Bauelementeträger und über eine Bauelementeträgerkennung, die dem Bauelementeträger zugeordnet ist und diesen eindeutig identifiziert.

4. Verfahren zur Herstellung nach einem der Ansprüche 1 bis 3, **dadurch gekennzeichnet, dass** jedes Bauelement oder eine Vorstufe jedes Bauelements in zumindest einem Herstellungsschritt des Verfahrens über das Auslesen des Informationsspeichers eindeutig identifiziert wird.

5. Verfahren zur Herstellung nach einem der Ansprüche 1 bis 4, **dadurch gekennzeichnet, dass** eine Stichprobe der Bauelemente oder dass jedes Bauelement einer Abschlusskontrolle unterzogen wird, bei der zumindest eine Eigenschaft des Bauelements gemessen wird, und Ergebnisse dieser Abschlusskontrolle dem Bauelement als Information zugeordnet werden.

6. Verfahren zur Herstellung nach Anspruch 5, **dadurch gekennzeichnet, dass** die bei der Abschlusskontrolle erhaltenen Ergebnisse mit vorgegebenen Sollwerten verglichen werden und Bauelemente ermittelt werden bei denen mindestens eine Überschreitung vorgegebener Grenzwerte vorliegt.

7. Verfahren zur Herstellung nach Anspruch 6, **dadurch gekennzeichnet, dass** für die ermittelten Bauelemente mit mindestens einer Grenzwertüberschreitung deren zugeordneten Informationen ausgewertet werden und für die ermittelten Bauelemente gemeinsame Informationen bestimmt werden, welche für die ermittelten Bauelemente identisch sind oder bis auf eine vorgegebene Toleranz übereinstimmen.

8. Verfahren zur Herstellung nach Anspruch 7, **dadurch gekennzeichnet, dass** aus den gemeinsamen Informationen Herstellungsschritte, Ausgangsmaterialien, Werkzeuge und/oder Prozessbedingungen ermittelt werden, welche diese Bauelemente gemeinsam haben, und dass entsprechend dem Ergebnis dieser Bestimmung Maßnahmen zur Qualitätsverbesserung zukünftiger Durchläufe des Verfahrens zur Herstellung eingeleitet werden, wobei diese Maßnahmen ausgewählt sind aus dem Austausch eines Werkzeugs, Austausch eines Bauelementeträgers, Austausch oder Eichung eines Messgeräts, Korrekturen von Prozessparametern, Auswahl anderer Ausgangsmaterialien und Kombinationen mehrerer dieser Maßnahmen.

9. Bauelement mit zumindest einer elektrischen Durchführung, bei der ein Funktionselement in einer Durchführungsöffnung eines Grundkörpers mittels eines elektrisch isolierenden Materials fixiert ist, vorzugsweise erhalten über ein Verfahren zur Herstellung nach einem der Ansprüche 1 bis 8, **dadurch gekennzeichnet, dass** das Bauelement einen Informationsspeicher umfasst.

10. Ensemble von Bauelementen mit zumindest einer elektrischen Durchführung, bei der ein Funktionselement in einer Durchführungsöffnung eines Grundkörpers mittels eines elektrisch isolierenden Materials fixiert ist, welche vorzugsweise nach einem der Ansprüche 1 bis 8 erhalten wurden, wobei das Ensemble von Bauelementen in einem Behälter aufgenommen ist, wobei der Behälter einen Ensembleinformationsspeicher umfasst, wobei der Ensembleinformationsspeicher Angaben zur Identifizierung der in dem Ensemble enthaltenen Bauelemente enthält.

11. Verfahren zur Weiterverarbeitung von Bauelementen nach Anspruch 9, einem Ensemble von Bauelementen nach Anspruch 10 oder von über das Verfahren nach einem der Ansprüche 1 bis 8 erhaltener Bauelemente zu Einheiten, welche jeweils mindestens eines dieser Bauelement enthalten, wobei jeweils einem Bauelement zugeordnete Informationen erhalten werden und jeweils einer der Einheiten zugeordnet werden, **dadurch gekennzeichnet, dass** das Erhalten der einem Bauelement zugeordneten Informationen ein Auslesen eines Informationsspeichers des Bauelements oder ein Auslesen eines Ensembleinformationsspeichers eines Behälters, der ein oder mehrere Bauelemente aufnimmt, umfasst.

12. Verfahren zur Weiterverarbeitung nach Anspruch 11, **dadurch gekennzeichnet, dass** in zumindest einem Weiterverarbeitungsschritt zumindest ein Parameter anhand von dem Bauelement zugeordneten Informationen angepasst wird.

13. Verfahren zur Weiterverarbeitung nach Anspruch 11 oder 12 **dadurch gekennzeichnet, dass** ein in den dem Bauelement zugeordneten Informationen enthaltener Parameter erneut gemessen wird und mit den zuvor ermittelten Informationen verglichen wird.

14. Verfahren zur Weiterverarbeitung nach Anspruch 13, **dadurch gekennzeichnet, dass** der Vergleich für mehrere Bauelemente wiederholt wird, welche eine Stichprobe aus einer Gesamtheit der Bauelemente sind oder für alle Bauelemente der Gesamtheit wiederholt wird, wobei bei Erkennen einer systematischen Abweichung ein Korrekturfaktor ermittelt wird, mit dem zugeordnete Informationen auch für nicht erneut vermessene Bauteile dieser Gesamtheit korrigiert werden.

15. Bauelement oder Verfahren nach einem der vorhergehenden Ansprüche, **dadurch gekennzeichnet, dass** Informationen, welche für eine Vielzahl von Bauelementen identisch sind, nur einmal als Gruppeninformationen in einer Datenbank gespeichert werden und dem Bauelement jeweils ein Verweis auf diese Gruppeninformationen zugeordnet wird.

16. Bauelement oder Verfahren nach einem der vorhergehenden Ansprüche, **dadurch gekennzeichnet, dass** der Informationsspeicher als eine optisch lesbare Markierung ausgestaltet ist, wobei die optisch lesbare Markierung vorzugsweise als ein Barcode oder als Matrixcode ausgestaltet ist, insbesondere als ein Data Matrix Code.

17. Bauelement oder Verfahren nach Anspruch 16, **dadurch gekennzeichnet, dass** die optisch lesbare Markierung auf einem der Funktionselemente, insbesondere durch eine Abfolge von Kerben ausgebildet ist.

18. Bauelement oder Verfahren nach einem der Ansprüche 16 oder 17, **dadurch gekennzeichnet, dass** die optisch lesbare Markierung über ein Lasermaterialbearbeitungsverfahren erhalten wird.

19. Vorrichtung zur Herstellung von Bauelementen mit zumindest einer elektrischen Durchführung, bei der ein Funktionselement in einer Durchführungsöffnung eines Grundkörpers mittels eines elektrisch isolierenden Materials fixiert ist, **dadurch gekennzeichnet, dass** die Vorrichtung Bearbeitungsmittel zum Versehen der Bauelemente mit einem Informationsspeicher umfasst und dass die Vorrichtung zur Ausführung eines der Verfahren nach einem der Ansprüche 1 bis 8 oder 15 bis 18 ausgebildet ist.

20. Vorrichtung zur Weiterverarbeitung von Bauelementen nach Anspruch 9, einem Ensemble von Bauelementen nach Anspruch 10 oder von über das Verfahren nach einem der Ansprüche 1 bis 8 oder 15 bis 18 erhaltener Bauelemente zu Einheiten, welche jeweils mindestens eines dieser Bauelemente enthalten, **dadurch gekennzeichnet, dass** die Vorrichtung Lesemittel zum Auslesen des Informationsspeichers der Bauelemente oder des Ensembleinformationsspeichers eines Behälters mit den Bauelementen umfasst und dass die Vorrichtung zur Ausführung eines der Verfahren nach einem der Ansprüche 11 bis 19 ausgebildet ist.

21. Verwendung eines Bauelements nach Anspruch 9 oder eines über das Verfahren nach einem der Ansprüche 1 bis 8 oder 15 bis 19 erhaltenen Bauelements in einer Anzündeeinheit für Airbags oder einem Anzünder für Gurtstraffer.
